(19) Europäisches Patentamt / European Patent Office / Office européen des brevets

(11) **EP 2 366 177 B1**

(12) **FASCICULE DE BREVET EUROPEEN**

(45) Date de publication et mention de la délivrance du brevet:
**21.10.2015 Bulletin 2015/43**

(51) Int Cl.:
*G10L 19/26* (2013.01)    *G10L 19/24* (2013.01)
*G10L 19/04* (2013.01)

(21) Numéro de dépôt: **09768200.9**

(22) Date de dépôt: **17.11.2009**

(86) Numéro de dépôt international:
**PCT/FR2009/052194**

(87) Numéro de publication internationale:
**WO 2010/058117 (27.05.2010 Gazette 2010/21)**

(54) **CODAGE DE SIGNAL AUDIONUMERIQUE AVEC MISE EN FORME DU BRUIT DANS UN CODEUR HIERARCHIQUE**

CODIEREN EINES AUDIO-DIGITALSIGNALS MIT RAUSCHTRANSFORMATION IN EINEM SKALIERBAREN CODIERER

ENCODING OF AN AUDIO-DIGITAL SIGNAL WITH NOISE TRANSFORMATION IN A SCALABLE ENCODER

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **18.11.2008 FR 0857839**

(43) Date de publication de la demande:
**21.09.2011 Bulletin 2011/38**

(73) Titulaire: **Orange**
**75015 Paris (FR)**

(72) Inventeurs:
• **KOVESI, Balazs**
**F-22300 Lannion (FR)**
• **RAGOT, Stéphane**
**F-22300 Lannion (FR)**
• **LE GUYADER, Alain**
**F-22300 Lannion (FR)**

(56) Documents cités:
WO-A-2007/093726    US-A1- 2007 208 557

• Y. Hiwasaki et al.: "G.711.1: A wideband extension to ITU-T G.711" 16th European Signal Processing Conference EUSIPCO 2008 25 août 2008 (2008-08-25), XP002562145 Lausanne Extrait de l'Internet: URL:http://www.eurasip.org/Proceedings/Eus ipco/Eusipco2008/papers/1569104469.pdf> [extrait le 2010-01-08] cité dans la demande
• HIWASAKI Y ET AL: "A G.711 EMBEDDED WIDEBAND SPEECH CODING FOR VOIP CONFERENCES" IEICE TRANSACTIONS ON INFORMATION AND SYSTEMS, INFORMATION & SYSTEMS SOCIETY, TOKYO, JP, vol. E89D, no. 9, 1 septembre 2006 (2006-09-01), pages 2542-2552, XP001542710 ISSN: 0916-8532
• LAPIERRE J, LEFEBVRE R, BESSETE R, MALENOVSKY V, SALAMI R: "Noise shaping in an ITU-T G.711-interoperable embedded codec" EUSIPCO, 16TH EUROPEAN SIGNAL PROCESSING CONFERENCE, [Online] 25 août 2008 (2008-08-25), - 29 septembre 2008 (2008-09-29) pages 1-5, XP002530134 Extrait de l'Internet: URL:http://www.eurasip.org/Proceedings/Eus ipco/Eusipco2008/papers/1569105406.pdf> [extrait le 2009-05-29]

**Description**

La présente invention concerne le domaine du codage des signaux numériques.

Le codage selon l'invention est adapté notamment pour la transmission et/ou le stockage de signaux numériques tels que des signaux audiofréquences (parole, musique ou autres).

La présente invention se rapporte plus particulièrement au codage de forme d'onde de type codage MICDA (pour "Modulation par Impulsion et Codage Différentiel Adaptatif') dit "ADPCM" (pour *"Adaptive Differential Pulse Code Modulation"*) en anglais et notamment au codage de type MICDA à codes imbriqués permettant de délivrer des indices de quantification à train binaire scalable.

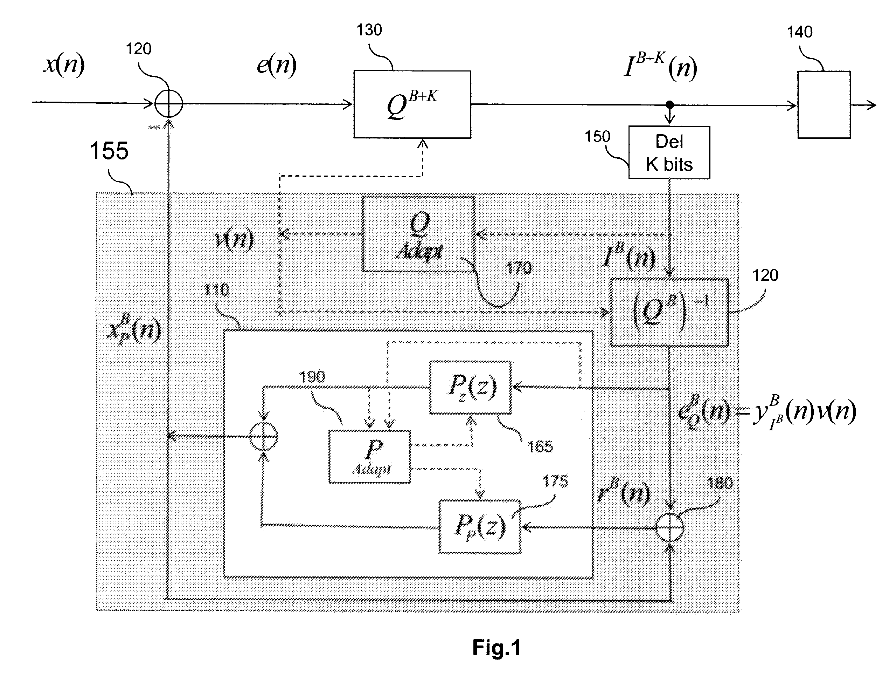

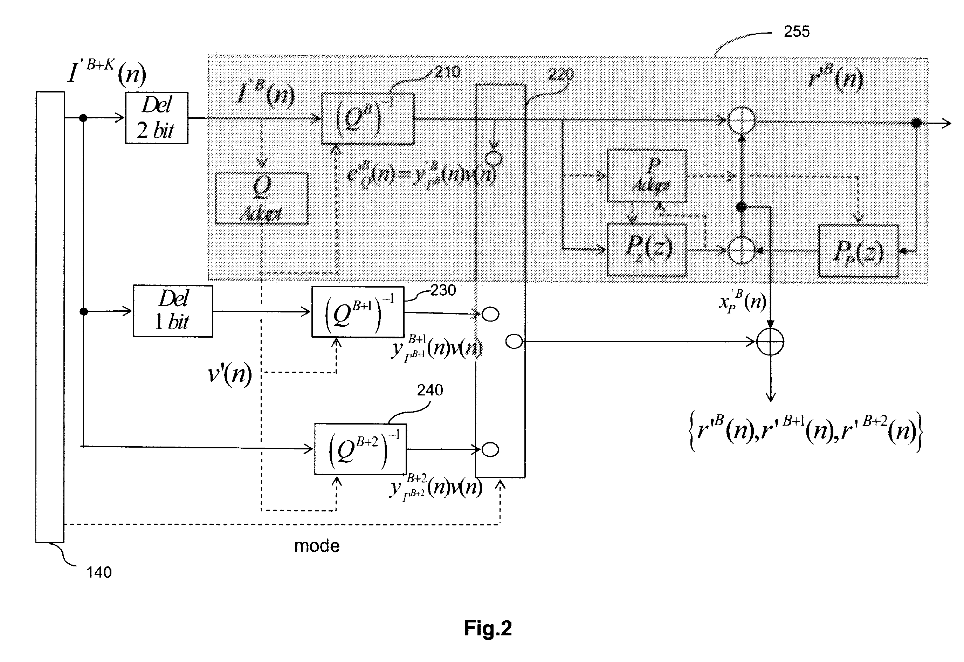

Le principe général du codage/décodage MICDA à codes imbriqués spécifié par la recommandation UIT-T G.722 ou UIT-T G.727 est tel que décrit en référence aux figures 1 et 2.

La **figure 1** représente ainsi un codeur à codes imbriqués de type MICDA.

Il comporte:

- un module de prédiction 110 permettant de donner la prédiction du signal $x_P^B(n)$ à partir des échantillons précédents du signal d'erreur quantifié $e_Q^B(n') = y_{I^B}^B(n')v(n')$ $n' = n-1,...,n-N_Z$, où $v(n')$ est le facteur d'échelle, et du signal reconstitué $r^B(n')$ $n' = n$-1,..., $n$-$N_P$ où n est l'instant courant.

- un module de soustraction 120 qui retranche du signal d'entrée $x(n)$ sa prédiction $x_P^B(n)$ pour obtenir un signal d'erreur de prédiction noté $e(n)$.

- un module de quantification 130 $Q^{B+K}$ du signal d'erreur qui reçoit en entrée le signal d'erreur $e(n)$ pour donner des indices de quantification $I^{B+K}(n)$ constitués de B+K bits. Le module de quantification $Q^{B+K}$ est à codes imbriqués c'est-à-dire qu'il comporte un quantificateur de coeur à B bits et des quantificateurs à $B + k$ $k$ = 1,..., $K$ bits qui sont imbriqués sur le quantificateur de coeur.

Dans le cas de la norme UIT-T G.722, les niveaux de décision et les niveaux de reconstruction des quantificateurs $Q^B$, $Q^{B+1}$, $Q^{B+2}$ pour $B$ = 4 sont définis par les tableaux IV et VI de l'article de synthèse décrivant la norme G.722 de X. Maitre. "7 kHz audio coding within 64 kbit/s". IEEE Journal on Selected Areas in Communication, Vol.6-2, February 1988.

L'indice de quantification $I^{B+K}(n)$ de $B + K$ bits en sortie du module de quantification $Q^{B+K}$ est transmis via le canal de transmission 140 au décodeur tel que décrit en référence à la figure 2.

Le codeur comporte également:

- un module 150 de suppression des K bits de poids faible de l'indice $I^{B+K}(n)$ pour donner un indice bas débit $I^B(n)$;
- un module de quantification inverse 120 $(Q^B)^{-1}$ pour donner en sortie un signal d'erreur quantifié $e_Q^B(n) = y_{I^B}^B(n)v(n)$ sur $B$ bits;
- un module d'adaptation 170 $Q_{Adapt}$ des quantificateurs et des quantificateurs inverses pour donner un paramètre de contrôle de niveau $v(n)$ encore appelé facteur d'échelle, pour l'instant suivant;
- un module d'addition 180 de la prédiction $x_P^B(n)$ au signal d'erreur quantifié pour donner le signal reconstruit à bas débit $r^B(n)$;
- un module d'adaptation 190 $P_{Adapt}$ du module de prédiction à partir du signal d'erreur quantifié sur B bits $e_Q^B(n)$ et du signal $e_Q^B(n)$ filtré par 1+$P_Z(z)$.

On peut remarquer que sur la figure 1 la partie en pointillés référencée 155 représente le décodeur local à bas débit qui contient les prédicteurs 165 et 175 et le quantificateur inverse 120. Ce décodeur local permet ainsi d'adapter le quantificateur inverse en 170 à partir de l'indice bas débit $I^B(n)$ et d'adapter les prédicteurs 165 et 175 à partir des données bas débit reconstruites.

Cette partie se retrouve à l'identique sur le décodeur MICDA à codes imbriqués tel que décrit en référence à la figure 2.

Le décodeur MICDA à codes imbriqués de la **figure 2** reçoit en entrée les indices $I'^{B+K}$ issu du canal de transmission 140, version de $I^{B+K}$ éventuellement perturbée par des erreurs binaires, et réalise une quantification inverse par le module de quantification inverse 210 $(Q^B)^{-1}$ de débit B bits par échantillon pour obtenir le signal $e_Q'^B(n) = y_{I'^B}'^B(n)v'(n)$. Le symbole " ' " indique une valeur reçue au décodeur, éventuellement différente de celle transmise par le codeur du fait d'erreurs de transmission.

Le signal de sortie $r'^B(n)$ pour B bits sera égal à la somme de la prédiction du signal et de la sortie du quantificateur inverse à B bits. Cette partie 255 du décodeur est identique au décodeur local bas débit 155 de la figure 1.

Moyennant l'indicateur de débit *mode* et le sélecteur 220, le décodeur peut améliorer le signal restitué.

En effet si *mode* indique que B+1 bits ont été transmis, la sortie sera égale à la somme de la prédiction $x_P^B(n)$ et de la sortie du quantificateur inverse 230 à B+1 bits $y'^{B+1}_{I^{B+1}}(n)v'(n)$.

Si *mode* indique que B+2 bits ont été transmis alors la sortie sera égale à la somme de la prédiction $x_P^B(n)$ et de la sortie du quantificateur inverse 240 à B+2 bits $y'^{B+2}_{I^{B+2}}(n)v'(n)$.

En utilisant les notations de la transformée en z, on peut écrire que dans cette structure bouclée :

$$R^{B+k}(z) = X(Z) + Q^{B+k}(z)$$

en définissant le bruit de quantification à B+k bits $Q^{B+k}(z)$ par :

$$Q^{B+k}(z) = E_Q^{B+k}(z) - E(z)$$

Le codage MICDA à codes imbriqués de la norme UIT-T G.722 (ci-après nommé G.722) réalise un codage des signaux en bande élargie qui sont définis avec une largeur de bande minimale de [50-7000 Hz] et échantillonnés à 16 kHz. Le codage G.722 est un codage MICDA de chacune des deux sous-bandes du signal [50-4000 Hz] et [4000-7000 Hz] obtenues par décomposition du signal par des filtres miroirs en quadrature. La bande basse est codée par un codage MICDA à codes imbriqués sur 6, 5 et 4 bits tandis que la bande haute est codée par un codeur MICDA de 2 bits par échantillon. Le débit total sera de 64, 56 ou 48 bit/s suivant le nombre de bits utilisé pour le décodage de la bande basse.

Ce codage a d'abord été utilisé dans le RNIS (Réseau Numérique à Intégration de Services) puis dans les applications de codage audio sur réseau IP.

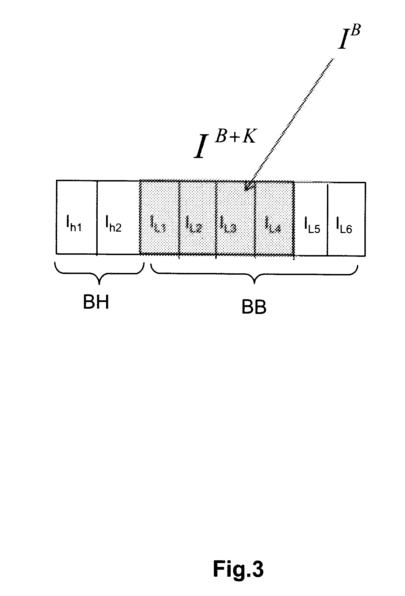

A titre d'exemple, dans la norme G.722, les 8 bits sont répartis de la façon suivante telle que représenté à la **figure 3**:

2 bits $I_{h1}$ et $I_{h2}$ pour la bande haute

6 bits $I_{L1}$, $I_{L2}$ $I_{L3}$ $I_{L4}$ $I_{L5}$ $I_{L6}$ pour la bande basse.

Les bits $I_{L5}$ et $I_{L6}$ peuvent être « volés » ou remplacés par des données et constituent les bits d'amélioration de la bande basse. Les bits $I_{L1,}$ $I_{L2}$ $I_{L3}$ $I_{L4}$ constituent les bits coeur de la bande basse.

Ainsi, une trame de signal quantifié selon la norme G.722 est constituée d'indices de quantification codés sur 8, 7 ou 6 bits. La fréquence de transmission de l'indice étant de 8 kHz, le débit sera de 64, 56 ou 48 kbit/s.

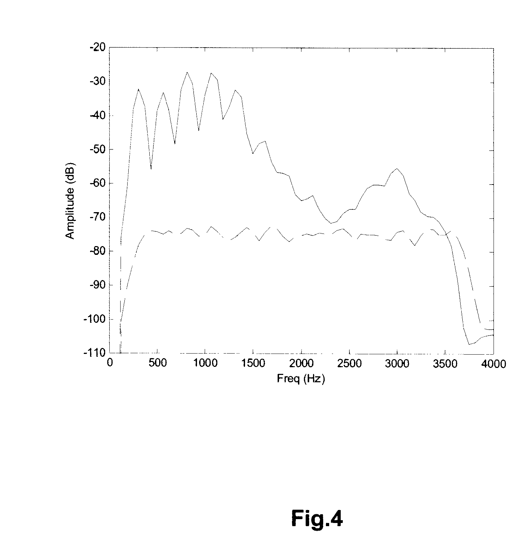

Pour un quantificateur à grand nombre de niveaux, le spectre du bruit de quantification sera relativement plat comme le montre la **figure 4**. Le spectre du signal est aussi représenté sur la figure 4 (ici un bloc de signal voisé). Ce spectre a une grande dynamique (~40dB). On peut voir que dans les zones de faible énergie, le bruit est très proche du signal et n'est donc plus forcément masqué. Il peut alors devenir audible dans ces régions, essentiellement dans la zone de fréquences [2000-2500 Hz] sur la figure 4.

Une mise en forme du bruit de codage est donc nécessaire. Une mise en forme du bruit de codage adaptée à un codage à codes imbriqués serait de plus souhaitable.

Une technique de mise en forme du bruit pour un codage de type MIC (pour "Modulation par Impulsions Codées") à codes imbriqués est décrite dans la recommandation UIT-T G.711.1 « Wideband embedded extension for G.711 pulse code modulation » ou «G.711.1: A wideband extension to ITU-T G.711 ». Y. Hiwasaki, S. Sasaki, H. Ohmuro, T. Mori, J. Seong, M. S. Lee, B. Kôvesi, S. Ragot, J.-L. Garcia, C. Marro ,L. M., J. Xu, V. Malenovsky, J. Lapierre, R. Lefebvre. EUSIPCO, Lausanne, 2008.

Cette recommandation décrit ainsi un codage avec mise en forme du bruit de codage pour un codage de débit coeur. Un filtre perceptuel de mise en forme du bruit de codage est calculé sur la base des signaux décodés passés, issus d'un quantificateur coeur inverse. Un décodeur local de débit coeur permet donc de calculer le filtre de mise en forme du bruit. Ainsi, au décodeur, il est possible de calculer ce filtre de mise en forme du bruit à partir des signaux décodés de débit coeur.

Un quantificateur délivrant des bits d'amélioration est utilisé au codeur.

Le décodeur recevant le flux binaire coeur et les bits d'amélioration, calcule le filtre de mise en forme du bruit de codage de la même façon qu'au codeur à partir du signal décodé de débit coeur et applique ce filtre au signal de sortie du quantificateur inverse des bits d'amélioration, le signal haut débit mis en forme étant obtenu en ajoutant le signal filtré au signal décodé de coeur.

La mise en forme du bruit améliore ainsi la qualité perceptuelle du signal de débit coeur. Elle offre une amélioration limitée de la qualité pour les bits d'amélioration. En effet, la mise en forme du bruit de codage n'est pas effectuée pour le codage des bits d'amélioration, l'entrée du quantificateur étant la même pour la quantification de coeur que pour la quantification améliorée.

Le décodeur doit alors supprimer une composante parasite résultante par un filtrage adapté, lorsque les bits d'amélioration sont décodés en plus des bits coeur.

Le calcul supplémentaire d'un filtre au décodeur augmente la complexité du décodeur.

Cette technique n'est pas utilisée dans les décodeurs scalables standards déjà existants de type décodeur G.722 ou G.727. Il existe donc un besoin d'amélioration de la qualité des signaux quelque soit le débit tout en restant compatible avec les décodeurs scalables standards existants.

La présente invention vient améliorer la situation.

A cet effet, elle propose un procédé de codage hiérarchique d'un signal audionumérique comportant pour une trame courante du signal d'entrée:

- un codage coeur, délivrant un indice de quantification scalaire pour chaque échantillon de la trame courante et
- au moins un codage d'amélioration délivrant des indices de quantification scalaire pour chaque échantillon codé d'un signal d'amélioration. Le procédé est tel que le codage d'amélioration comporte une étape d'obtention d'un filtre de mise en forme du bruit de codage utilisé pour déterminer un signal cible et en ce que les indices de quantification scalaire du dit signal d'amélioration, sont déterminés en minimisant l'erreur entre un ensemble de valeurs de quantification scalaire possibles et ledit signal cible.

Ainsi, une mise en forme du bruit de codage du signal d'amélioration de plus haut débit est effectuée. La méthode d'analyse par synthèse faisant l'objet de l'invention ne nécessite pas d'effectuer au décodeur, de traitement de signal complémentaire comme ceci peut être le cas dans les solutions de mise en forme du bruit de codage de l'état de l'art.

Le signal reçu au décodeur pourra donc être décodé par un décodeur standard apte à décoder le signal de débit coeur et de débits imbriqués qui ne nécessite pas de calcul de mise en forme du bruit ni de terme correctif.

La qualité du signal décodé est donc améliorée quelque soit le débit disponible au décodeur.

Les différents modes particuliers de réalisation mentionnés ci-après peuvent être ajoutés indépendamment ou en combinaison les uns avec les autres, aux étapes du procédé défini ci-dessus.

Ainsi, un mode de réalisation de la détermination du signal cible est tel que pour un étage de codage d'amélioration courant, le procédé comporte les étapes suivantes pour un échantillon courant:

- obtention d'un signal d'erreur de codage d'amélioration par combinaison du signal d'entrée du codage hiérarchique avec un signal reconstruit partiellement à partir d'un codage d'un étage de codage précédent et des échantillons passés des signaux reconstruits de l'étage de codage d'amélioration courant;
- filtrage par le filtre de mise en forme du bruit obtenu, du signal d'erreur de codage d'amélioration pour obtenir le signal cible;
- calcul du signal reconstruit pour l'échantillon courant par addition du signal reconstruit issu du codage de l'étage précédent et du signal issu de l'étape de quantification;
- adaptation de mémoires du filtre de mise en forme du bruit à partir du signal issu de l'étape de quantification.

L'agencement des opérations décrit ici conduit à une mise en forme du bruit de codage par des opérations de complexité très réduite.

Dans un mode particulier de réalisation, l'ensemble des valeurs de quantification scalaire possibles et la valeur de quantification du signal d'erreur pour l'échantillon courant sont des valeurs désignant des niveaux de reconstruction de quantification, mises à l'échelle par un paramètre de contrôle de niveau calculé par rapport aux indices de quantification de débit coeur.

Ainsi, les valeurs sont adaptées au niveau de sortie du codage coeur.

Dans un mode particulier de réalisation, les valeurs désignant des niveaux de reconstructions de quantification pour un étage d'amélioration k sont définis par la différence entre les valeurs désignant les niveaux de reconstruction de la quantification d'un quantificateur imbriqué à B+k bits, B désignant le nombre de bits du codage coeur et les valeurs désignant les niveaux de reconstruction de quantification d'un quantificateur imbriqué à B+k-1 bits, les niveaux de reconstruction du quantificateur imbriqué à B+k bits étant définis par dédoublement des niveaux de reconstruction du quantificateur imbriqué à B+k-1 bits.

De plus, les valeurs désignant des niveaux de reconstruction de quantification pour l'étage d'amélioration k sont stockés dans un espace mémoire et indexés en fonction des indices de quantification de débit coeur et d'amélioration.

Les valeurs de sortie du quantificateur d'amélioration, directement stockées en ROM, ne sont pas à recalculer pour chaque instant d'échantillonnage par soustraction des valeurs de sortie du quantificateur à B+k bit à celles du quantificateur à B+k-1 bits. Elles sont de plus par exemple rangées 2 par 2 dans une table facilement indexable par l'indice de l'étage précédent.

Dans un mode de réalisation particulier, le nombre de valeurs de quantification scalaire possibles varie pour chaque échantillon.

Ainsi, il est possible d'adapter le nombre de bits d'amélioration en fonction des échantillons à coder.

Dans une autre variante de réalisation, le nombre d'échantillons codés dudit signal d'amélioration donnant les indices de quantification scalaire est inférieur au nombre d'échantillons du signal d'entrée.

Ceci peut par exemple être le cas lorsque le nombre de bits d'amélioration alloué est mis à zéro pour certains échantillons.

Un mode de réalisation possible du codage coeur est par exemple un codage MICDA utilisant une quantification scalaire et un filtre de prédiction.

Un autre mode de réalisation possible du codage coeur est par exemple, un codage MIC.

Le codage coeur peut également comporter une mise en forme du bruit de codage par exemple avec les étapes suivantes pour un échantillon courant:

- obtention d'un signal de prédiction du bruit de codage à partir d'échantillons de bruit de quantification passés et à partir d'échantillons passés d'un bruit de quantification filtré par un filtre de mise en forme du bruit prédéterminé;
- combinaison du signal d'entrée du codage coeur et du signal de prédiction du bruit de codage pour obtenir un signal d'entrée modifié à quantifier.

Une mise en forme du bruit de codage de moindre complexité est ainsi réalisée pour le codage coeur.

Dans un mode de réalisation particulier, le filtre de mise en forme du bruit est défini par un filtre ARMA ou une succession de filtres ARMA.

Ainsi, ce type de fonction de pondération comportant une valeur au numérateur et une valeur au dénominateur a l'avantage par la valeur au dénominateur de prendre en compte les pics de signal et par la valeur au numérateur d'atténuer ces pics apportant ainsi une mise en forme optimale du bruit de quantification. La succession de filtre ARMA en cascade permet de mieux modéliser le filtre de masquage par des composantes de modélisation de l'enveloppe du spectre du signal et de composantes de périodicité ou de quasi-périodicité.

Dans un mode particulier de réalisation, le filtre de mise en forme du bruit est décomposé en deux cellules de filtrage ARMA en cascade de pente spectrale et d'allure formantique découplées.

Ainsi, chaque filtre est adapté en fonction des caractéristiques spectrales du signal d'entrée et convient donc aux signaux présentant divers types de pentes spectrales.

Avantageusement, le filtre de mise en forme du bruit (W(z)) utilisé par le codage d'amélioration est également utilisé par le codage coeur, réduisant ainsi la complexité d'implémentation.

Dans un mode de réalisation particulier, le filtre de mise en forme du bruit est calculé en fonction dudit signal d'entrée de façon à s'adapter au mieux à des signaux d'entrée différents.

Dans une variante de réalisation, le filtre de mise en forme du bruit est calculé à partir d'un signal localement décodé par le codage coeur.

La présente invention se rapporte également à un codeur hiérarchique d'un signal audionumérique pour une trame courante du signal d'entrée comportant:

- un étage de codage coeur, délivrant un indice de quantification scalaire pour chaque échantillon de la trame courante; et
- au moins un étage de codage d'amélioration délivrant des indices de quantification scalaire pour chaque échantillon codé d'un signal d'amélioration.

Le codeur est tel que l'étage de codage d'amélioration comporte un module d'obtention d'un filtre de mise en forme du bruit de codage utilisé pour déterminer un signal cible et un module de quantification délivrant les indices de quantification scalaire dudit signal d'amélioration en minimisant l'erreur entre un ensemble de valeurs de quantification scalaire possibles et ledit signal cible.

Elle se rapporte aussi à un programme informatique comportant des instructions de code pour la mise en oeuvre des étapes du procédé de codage selon l'invention, lorsque ces instructions sont exécutées par un processeur.

L'invention se rapporte enfon à un moyen de stockage lisible par un processeur mémorisant un programme informatique tel que décrit.

D'autres caractéristiques et avantages de l'invention apparaîtront plus clairement à la lecture de la description suivante, donnée uniquement à titre d'exemple non limitatif, et faite en référence aux dessins annexés, sur lesquels:

- la figure 1 illustre un codeur de type MICDA à codes imbriqués selon l'état de l'art et tel que décrit précédemment;
- la figure 2 illustre un décodeur de type MICDA à codes imbriqués selon l'état de l'art et tel que décrit précédemment;
- la figure 3 illustre un exemple de trame d'indices de quantification d'un codeur de type MICDA à codes imbriqués selon l'état de l'art et tel que décrit précédemment;
- la figure 4 représente un spectre d'un bloc de signal par rapport au spectre d'un bruit de quantification présent dans un codeur n'implémentant pas la présente invention;
- la figure 5 représente un schéma bloc d'un codeur à codes imbriqués et d'un procédé de codage selon un mode général de réalisation de l'invention;
- les figures 6a et 6b représentent un schéma bloc d'un étage de codage d'amélioration et d'un procédé de codage d'amélioration selon l'invention;
- la figure 7 illustre différentes configurations de décodeurs adaptés au décodage d'un signal issu du codage selon l'invention;
- la figure 8 représente un schéma bloc d'un premier mode détaillé de réalisation d'un codeur selon l'invention et d'un procédé de codage selon l'invention;
- la figure 9 illustre un exemple de calcul d'un bruit de codage pour l'étage de codage coeur d'un codeur selon l'invention;
- la figure 10 illustre une fonction détaillée de calcul d'un bruit de codage de la figure 9;
- la figure 11 illustre un exemple d'obtention d'un ensemble de niveaux de reconstruction de quantification selon le procédé de codage de l'invention;
- la figure 12 illustre une représentation du signal d'amélioration selon le procédé de codage de l'invention;
- la figure 13 illustre un organigramme représentant les étapes d'un premier mode de réalisation du calcul du filtre de masquage pour le codage selon l'invention;
- la figure 14 illustre un organigramme représentant les étapes d'un second mode de réalisation du calcul du filtre de masquage pour le codage selon l'invention;
- la figure 15 représente un schéma bloc d'un deuxième mode de réalisation détaillé d'un codeur selon l'invention et d'un procédé de codage selon l'invention;
- la figure 16 représente un schéma bloc d'un troisième mode de réalisation détaillé d'un codeur selon l'invention et d'un procédé de codage selon l'invention; et
- la figure 17 représente un mode de réalisation possible d'un codeur selon l'invention.

Dans la suite du document, le terme "prédiction" est systématiquement employé pour décrire des calculs utilisant uniquement des échantillons passés.

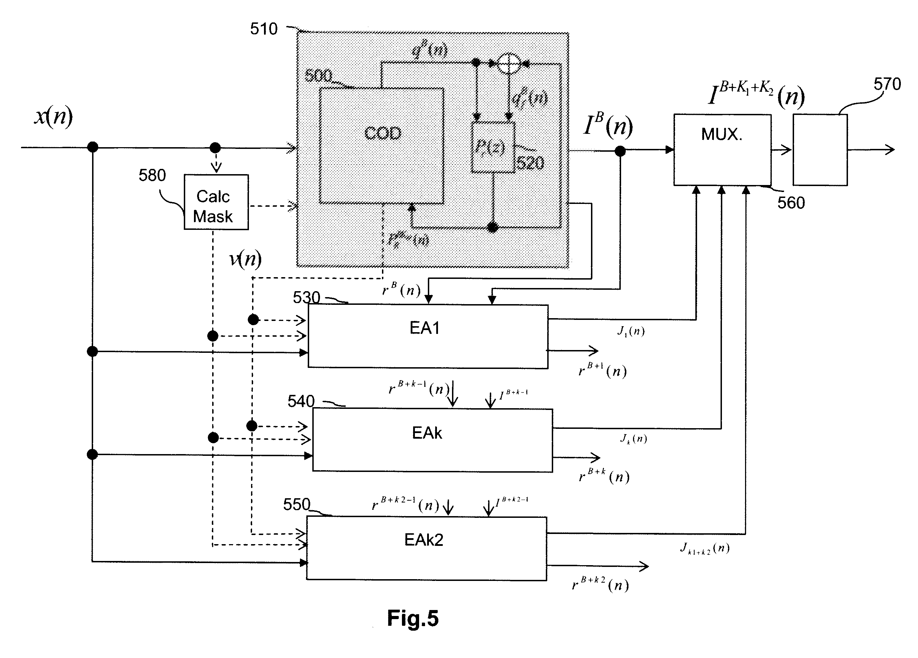

En référence à la **figure 5**, un codeur à codes imbriqués selon l'invention est maintenant décrit. Il est important de noter que le codage s'effectue avec des étages d'amélioration apportant un bit par échantillon supplémentaire. Cette contrainte n'est utile ici que pour simplifier la présentation de l'invention. Il est cependant clair que l'invention décrite ci-après se généralise facilement au cas où les étages d'amélioration apportent plus d'un bit par échantillon.

Ce codeur comporte un étage de codage de débit coeur 500 avec quantification sur B bits, de type par exemple codage MICDA tel que le codeur normalisé G.722 ou G.727 ou MIC pour "Modulation par Impulsions Codées" ou PCM en anglais (pour "Pulse code Modulation") tel que le codeur normalisé G.711 et modifié en fonction des sorties du bloc 520.

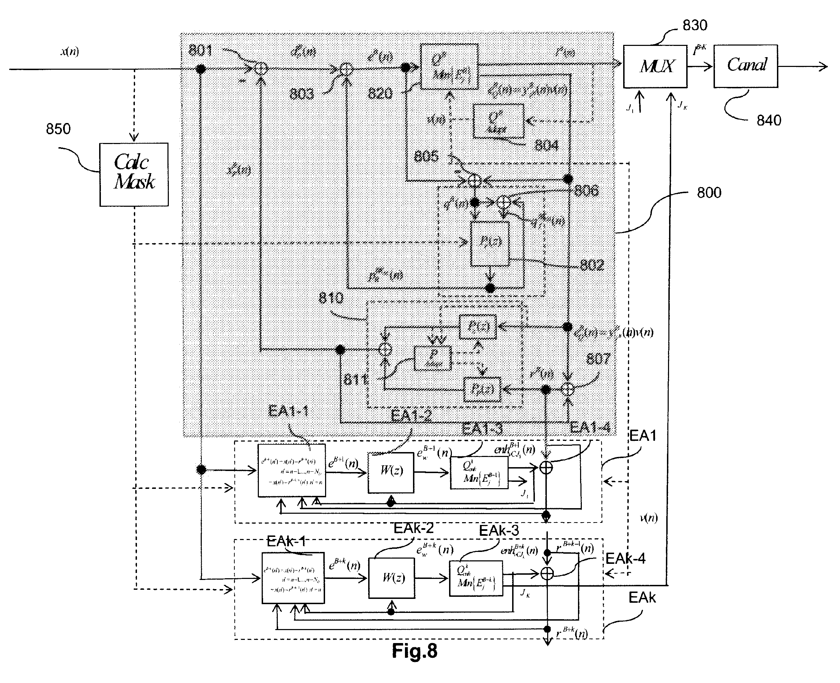

Le bloc référencé 510 représente cet étage de codage coeur avec mise en forme du bruit de codage, c'est-à-dire masquage du bruit du codage coeur, décrit plus en détails ultérieurement en référence aux figures 8, 15 ou 16.

L'invention telle que présentée, se rapporte également dans le cas où on n'effectue pas de masquage du bruit de codage dans la partie coeur. Par ailleurs, le terme "codeur coeur" est utilisé au sens large dans ce document. Ainsi on peut considérer comme "codeur coeur" un codeur multi-débits existant comme par exemple UIT-T G.722 à 56 ou 64 kbit/s. A l'extrême on peut également considérer un codeur coeur à 0 kbit/s, c'est-à-dire appliquer la technique de codage d'amélioration qui fait l'objet de de la présente invention dès la première étape du codage. Dans ce dernier cas le codage d'amélioration devient codage coeur.

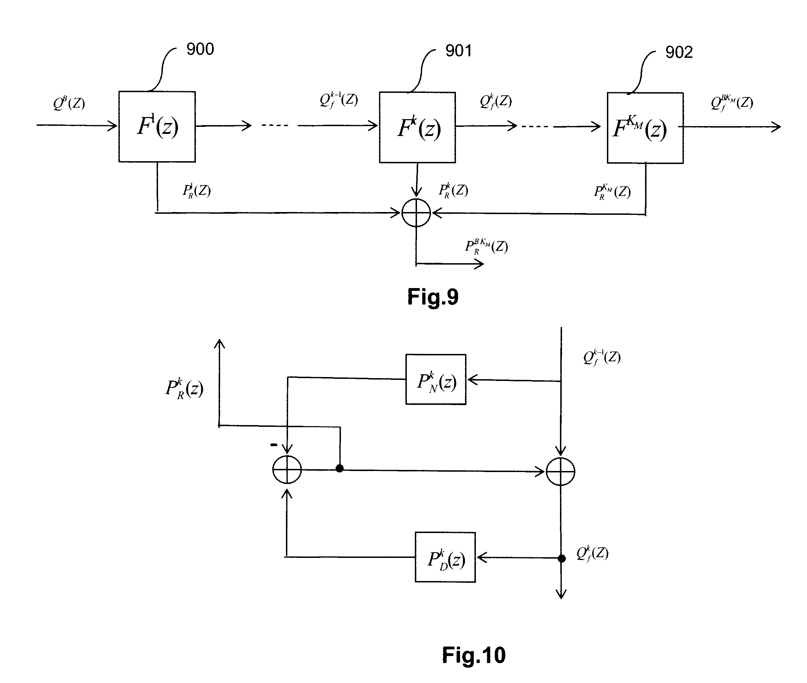

L'étage de codage coeur décrit ici en référence à la figure 5, avec mise en forme du bruit comporte un module de filtrage 520 effectuant la prédiction $P_r(z)$ à partir du bruit de quantification $q^B(n)$ et du bruit de quantification filtré $q_f^B(n)$ pour fournir un signal de prédiction $p_R^{BK_M}(n)$. Le bruit de quantification filtré $q_f^B(n)$ est obtenu par exemple en ajoutant $K_M$ prédictions partielles du bruit filtré au bruit de quantification tel que décrit ultérieurement en référence à la figure 9.

L'étage de codage coeur reçoit en entrée le signal $x(n)$ et fournit en sortie l'indice de quantification $I^B(n)$, le signal reconstruit $r^B(n)$ à partir de $I^B(n)$ et le facteur d'échelle du quantificateur $v(n)$ dans le cas par exemple d'un codage MICDA comme décrit en référence à la figure 1.

Le codeur tel que représenté en figure 5 comporte également plusieurs étages de codage d'amélioration. L'étage EA1 (530), l'étage EAk (540) et l'étage EAk2 (550) sont ici représentés.

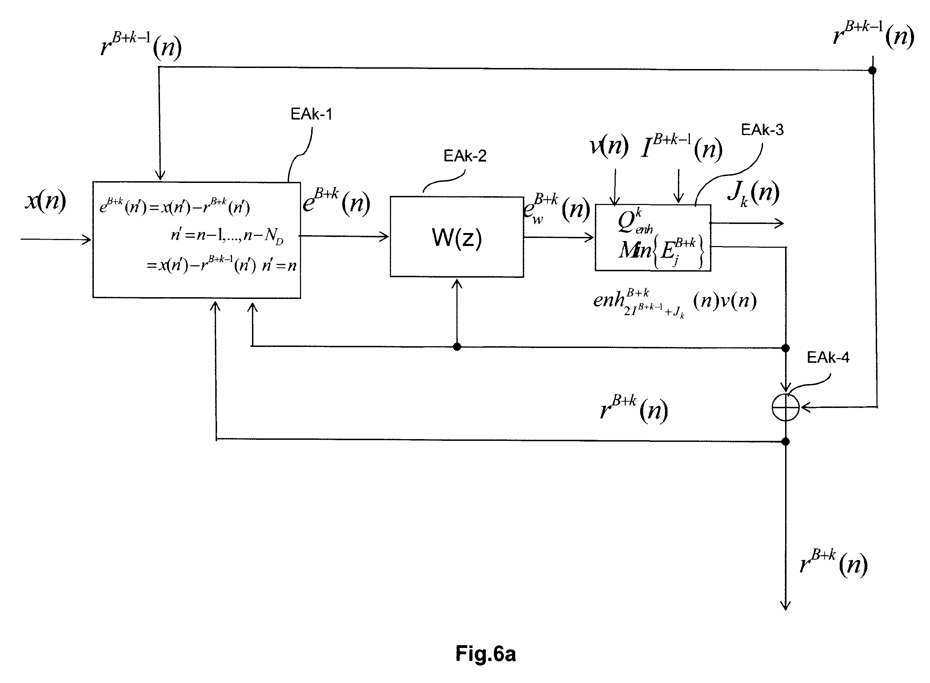

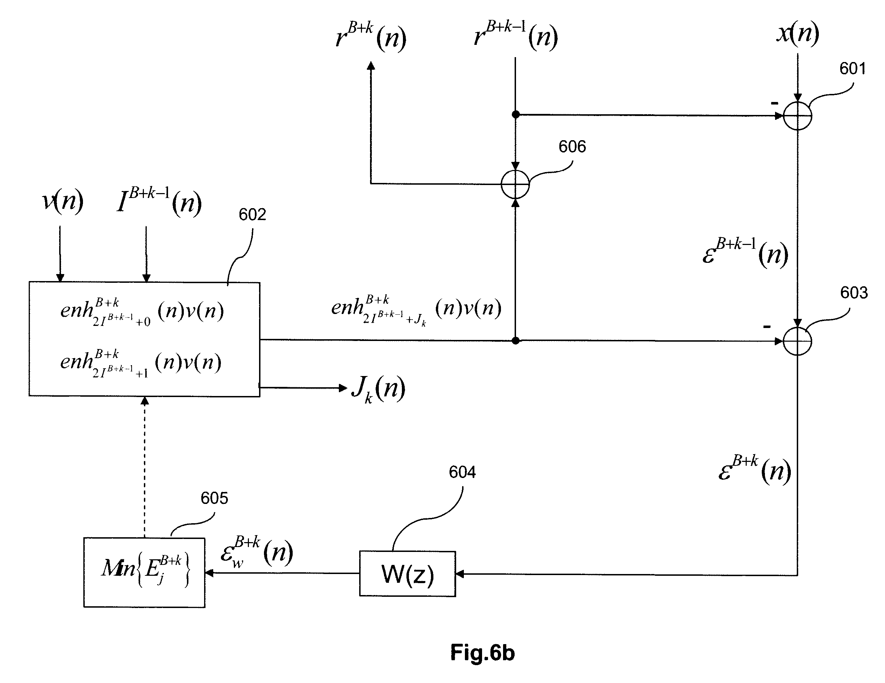

Un étage de codage d'amélioration ainsi représenté sera détaillé ultérieurement en référence aux figures 6a et 6b.

De façon générale, chaque étage k de codage d'amélioration a pour entrée le signal $x(n)$, l'indice optimal $I^{B+k-1}(n)$, concaténation de l'indice $I^B(n)$ du codage coeur et des indices des étages d'amélioration précédents $J_1(n),...,J_{k-1}(n)$ ou de façon équivalente l'ensemble de ces indices, le signal reconstruit à l'étape précédente $r^{B+k-1}(n)$, les paramètres du filtre de masquage et le cas échéant, le facteur d'échelle $v(n)$ dans le cas d'un codage adaptatif.

Cet étage d'amélioration fournit en sortie l'indice $J_k(n)$ de quantification des bits d'amélioration de cet étage de codage qui sera concaténé avec l'indice $I^{B+k-1}(n)$ dans le module de concaténation 560. L'étage d'amélioration k fournit également en sortie le signal reconstruit $r^{B+k}(n)$. Il est à noter que l'indice $J_k(n)$ représente ici un bit pour chaque échantillon d'indice n; cependant dans le cas général $J_k(n)$ peut représenter plusieurs bits par échantillon si le nombre de valeurs de quantification possibles est supérieur à 2.

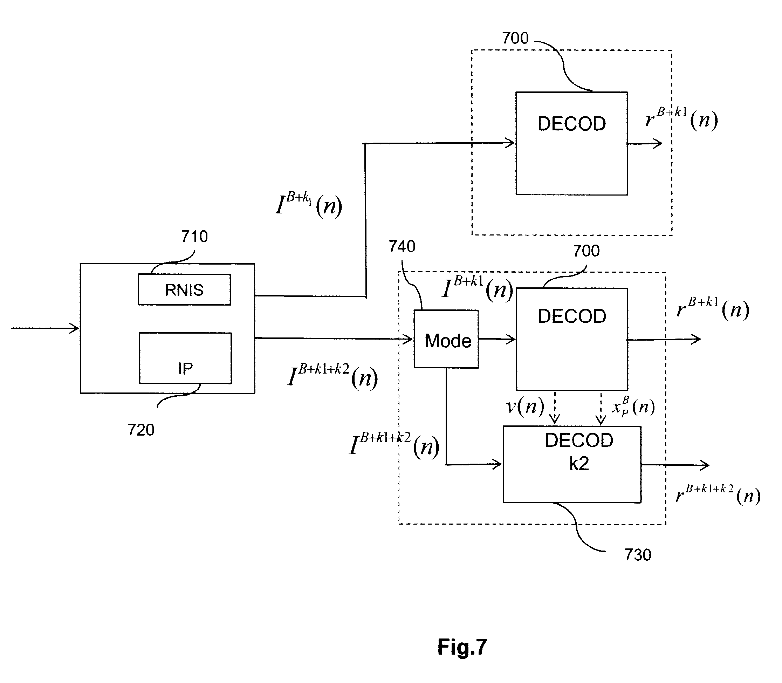

Certains des étages correspondent à des bits à transmettre $J_1(n),..., J_{k1}(n)$ qui seront concaténés à l'indice $I^B(n)$ de sorte que l'indice résultant puisse être décodé par un décodeur standard tel que représenté et décrit ultérieurement en figure 7. Il n'est donc pas nécessaire de changer le décodeur distant; de plus, aucune information supplémentaire n'est nécessaire pour "informer" le décodeur distant des traitements effectués au codeur.

D'autres bits $J_{k1+1}(n),...,J_{k2}(n)$ correspondent à des bits d'amélioration par augmentation du débit et masquage et nécessitent un module de décodage supplémentaire décrit en référence à la figure 7.

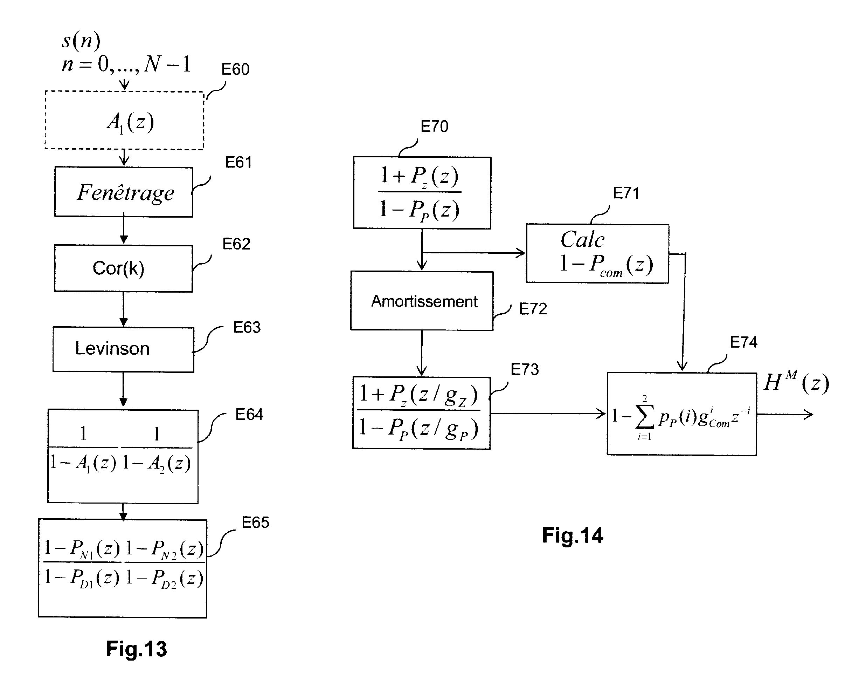

Le codeur de la figure 5 comporte également un module 580 de calcul du filtre de mise en forme du bruit ou filtre de masquage, à partir du signal d'entrée ou des coefficients des filtres de synthèse du codeur comme décrit ultérieurement en référence aux figures 13 et 14. A noter que le module 580 pourrait avoir en entrée le signal décodé localement plutôt que le signal original.

Les étages de codage d'amélioration tels que représentés ici permettent de fournir des bits d'amélioration offrant une qualité accrue du signal au décodeur, quelque soit le débit du signal décodé et sans modifier le décodeur et donc sans aucune complexité additionnelle au décodeur.

Ainsi, un module Eak de la figure 5 représentant un étage k de codage d'amélioration selon un mode de réalisation de l'invention est maintenant décrit en référence à la **figure 6a**.

Le codage d'amélioration effectué par cet étage de codage comporte une étape de quantification $Q^k_{enh}$ qui délivre en sortie un indice et une valeur de quantification minimisant l'erreur entre un ensemble de valeurs de quantification possibles et un signal cible déterminé par utilisation du filtre de mis en forme du bruit de codage.

On se place ici dans le cadre de codeurs comportant des quantificateurs à codes imbriqués.

L'étage k permet d'obtenir le bit d'amélioration $J_k$ ou un groupe de bits $J_k$ $k = 1,..., G_K$.

Il comporte un module EAk-1 de soustraction au signal d'entrée $x(n)$ du signal synthétisé à l'étage k $r^{B+k}(n)$ pour chaque échantillon précédent $n' = n - 1,..., n - N_D$ d'une trame courante et du signal $r^{B+k-1}(n)$ de l'étage précédent pour l'échantillon $n$, pour donner un signal d'erreur de codage $e^{B+k}(n)$.

Plutôt que de minimiser un critère d'erreur quadratique qui va engendrer un bruit de quantification à spectre plat comme représenté en référence à la figure 4, on va minimiser un critère d'erreur quadratique pondéré à l'étape de quantification, afin que le bruit mis en forme spectralement soit moins audible.

L'étage k comporte ainsi un module de filtrage EAk-2 du signal d'erreur $e^{B+k}(n)$ par la fonction de pondération $W(z)$. Cette fonction de pondération peut être également utilisée pour la mise en forme du bruit dans l'étage de codage coeur.

Le filtre de mise en forme du bruit est ici égal à l'inverse de la pondération spectrale, c'est-à-dire:

$$H^M(z) = \frac{1 - P_N^M(z)}{1 - P_D^M(z)} = \frac{1}{W(z)} \qquad (1)$$

Ce filtre de mise en forme est de type ARMA ("AutoRegressive Moving Average" en Anglais). Sa fonction de transfert comprend un numérateur d'ordre $N_N$ et un dénominateur d'ordre $N_D$. Ainsi, le bloc EAk-1 sert essentiellement à définir les mémoires de la partie non-récursive du filtre W(z), qui correspondent au dénominateur de $H^M(z)$. La définition des mémoires de la partie récursive de W(z) n'est pas montrée par souci de concision, mais elle se déduit de $e_w^{B+k}(n)$ et

de $enh^{B+k}_{2I^{B+k-1}+J_k}(n)v(n)$ .

Ce module de filtrage donne en sortie, un signal filtré $e^{B+k}_w(n)$ correspondant au signal cible.

Le rôle de la pondération spectrale est de mettre en forme le spectre de l'erreur de codage, ce qui est réalisé en minimisant l'énergie de l'erreur pondérée.

Un module de quantification EAk-3 effectue l'étape de quantification qui, à partir de valeurs possibles de sortie de quantification, cherche à minimiser le critère d'erreur pondérée selon l'équation suivante:

$$E^{B+k}_j = \left[ e^{B+k}_w(n) - enh^{B+k}_{VCj}(n) \right]^2 \quad j = 0,1 \qquad (2)$$

Cette équation représente le cas où un bit d'amélioration est calculé pour chaque échantillon *n*. Deux valeurs de sortie du quantificateur sont alors possibles. Nous verrons par la suite comment sont définies les valeurs possibles de sortie de l'étape de quantification.

Ce module EAk-3 réalise ainsi une quantification d'amélioration $Q^k_{enh}$ ayant pour première sortie la valeur du bit optimal $J_k$ à concaténer à l'indice de l'étage précédent $I^{B+k-1}$ et pour deuxième sortie $enh^{B+k}_{VCJ_k}(n) = enh^{B+k}_{2I^{B+k-1}+J_k}(n)v(n)$ , le signal de sortie du quantificateur pour l'indice optimal $J_k$ où $v(n)$ représente un facteur d'échelle défini par le codage coeur pour adapter le niveau de sortie des quantificateurs.

L'étage de codage d'amélioration comporte enfin un module EAk-4 d'addition du signal d'erreur quantifiée $enh^{B+k}_{2I^{B+k-1}+J_k}(n)v(n)$ au signal synthétisé à l'étage précédent $r^{B+k-1}(n)$ pour donner le signal synthétisé à l'étage k $r^{B+k}(n)$. De façon équivalente, $r^{B+k}(n)$ peut être obtenu en remplacement de EAk-4 en décodant l'indice $I^{B+k}(n)$, c'est-à-dire en calculant $\left[ y^{B+k}_{2I^{B+k-1}+J_k}v(n) \right]_F$ , éventuellement en précision finie, et en ajoutant la prédiction $x^B_P(n)$. Dans ce cas il convient de stocker en mémoire les valeurs de quantification $y^{B+k}_{2I^{B+k-1}+j}$ des quantificateurs à B bits, B+1,... et de calculer les valeurs du quantificateur d'amélioration par

$$\left[ enh^{B+k}_{2I^{B+k-1}+j}v(n) \right]_F = \left[ y^{B+k}_{2I^{B+k-1}+j}v(n) \right]_F - \left[ y^{B+k-1}_{I^{B+k-1}}v(n) \right]_F \quad .$$

Le signal $e^{B+k}(n)$ qui avait une valeur égale à $x(n') - r^{B+k-1}(n')$ pour n'=n est complété selon la relation suivante pour l'instant d'échantillonnage suivant:

$$e^{B+k}(n) \leftarrow e^{B+k}(n) - enh^{B+k}_{2I^{B+k-1}+J_k}(n)v(n) \qquad (3)$$

où $e^{B+k}(n)$ est aussi la mémoire MA (pour "Moyenne Ajustée") du filtre. Le nombre d'échantillons à garder en mémoire est donc égal au nombre de coefficients du dénominateur du filtre de mise en forme du bruit.

La mémoire de la partie AR (pour "Auto Regressif") du filtrage est alors mise à jour selon l'équation suivante:

$$e^{B+k}_w(n) \leftarrow e^{B+k}_w(n) - enh^{B+k}_{2I^{B+k-1}+J_k}(n)v(n) \qquad (5)$$

Dans le cas d'un filtrage par agencement de plusieurs cellules ARMA en cascade, les variables internes des filtres en référence à la figure 10 sont adaptées de la même façon :

$$q^k_f(n) \leftarrow q^k_f(n) - enh^{B+k}_{2I^{B+k-1}+J_k}(n)v(n)$$

L'indice *n* est incrémenté d'une unité. Une fois l'étape d'initialisation effectuée pour les $N_D$ premiers échantillons, le calcul de $e^{B+k}(n)$ se fera en décalant la mémoire de stockage de $e^{B+k}(n)$ (ce qui implique d'écraser l'échantillon le plus ancien) et en insérant dans la case laissée libre la valeur $e^{B+k}(n) = x(n) - r^{B+k-1}(n)$.

On peut noter que l'invention montrée à la figure 6a peut être réalisée par des variantes équivalentes. En effet, le signal reconstruit peut être décomposé en une partie $s_{det}(n)$ déterminée uniquement par les échantillons déjà disponibles (échantillons passés $n' = n - 1,..., n - N_D$, échantillons présents des étages précédents, mémoires des filtres) et une autre partie à déterminer $s_{opt}(n)$ dépendant uniquement de l'échantillon présent à optimiser. Ainsi, pour optimiser la charge de calcul, le calcul de l'erreur à minimiser $E_j^{B+k} = \left[ e_w^{B+k}(n) - enh_{VCj}^{B+k}(n) \right]^2 \quad j = 0,$ 1, qui est l'erreur pondérée entre le signal d'entrée $x(n)$ et le signal reconstruit $r^{B+k}(n)$, peut être également décomposé en deux parties. Dans une première étape on calcule la différence pondérée par $W(z)$ entre l'échantillon d'entrée $x(n)$ et $s_{det}(n)$ (modules EAK-1 et EAK-2 de la figure 6a). La valeur ainsi obtenu $e_{w'}^{B+k}(n)$ est le signal cible à l'instant $n$ qui se réduit à une seule valeur cible, elle est à calculer une seule fois pour chaque valeur possible de quantification $enh_{VCj}^{B+k}(n)$. Puis dans la boucle d'optimisation on doit simplement trouver parmi toute les valeurs de quantification scalaire possible celle qui est la plus proche au sens de la distance euclidienne de cette valeur cible.

Une autre variante de calcul de la valeur cible est de réaliser deux filtrages de pondération $W(z)$. Le premier pondère la différence entre le signal d'entrée et le signal reconstruit de l'étage précédent $r^{B+k-1}(n)$, Le deuxième filtre a une entrée nulle mais ces mémoires sont mises à jour à l'aide de $enh_{2 I^{B+k-1} + J_k}^{B+k}(n)v(n)$. La différence entre les sorties de ces deux filtrages donne le même signal cible.

Le principe de l'invention décrit à la figure 6a est généralisé à la figure 6b. Le bloc 601 donne l'erreur de codage de l'étage précédent $\varepsilon^{B+k-1}(n)$. Le bloc 602 dérive une à une toutes les valeurs de quantification scalaire possibles $enh_{2 I^{B+k-1} + J_k}^{B+k}(n)v(n)$, lesquelles sont soustraites à $\varepsilon^{B+k-1}(n)$ par le bloc 603 pour obtenir l'erreur de codage $\varepsilon^{B+k}(n)$ de l'étage courant. Cette erreur est pondérée par le filtre de mise en forme de bruit W(z) (bloc 604) et minimisée (bloc 605) pour commander le bloc 602. Finalement la valeur localement décodée par l'étage de codage d'amélioration est

$$r^{B+k}(n) = r^{B+k-1}(n) + enh_{2 I^{B+k-1} + J_k}^{B+k}(n)v(n) \text{ (bloc 606).}$$

Il est important de remarquer ici que la notation $^{B+k}$ suppose que le débit par échantillon est de B+k bits. La figure 6 traite donc du cas où un seul bit par échantillon est ajouté par l'étage de codage d'amélioration, ce qui implique 2 valeurs possibles de quantification dans le bloc 602. Il est évident que le codage d'amélioration décrit à la figure 6b peut générer un nombre quelconque de bits $k$ par échantillon ; dans ce cas, le nombre de valeurs de quantification scalaires possibles dans le bloc 602 est $2^k$.

En référence à la **figure 7**, nous allons à présent décrire différentes configurations de décodeurs à codes imbriquées aptes à décoder le signal obtenu en sortie d'un codeur selon l'invention et tel que décrit en référence à la figure 5.

Le dispositif de décodage mis en oeuvre dépend du débit de transmission du signal et par exemple de la provenance du signal selon qu'il provient d'un réseau RNIS 710 par exemple ou d'un réseau IP 720.

Pour un canal de transmission à faible débit (48, 56 ou 64 kbit/s), il sera possible d'utiliser un décodeur standard 700 par exemple de type décodeur MICDA normalisé G.722, pour décoder un train binaire de B+kl bits avec k1=0, 1, 2 et B le nombre de bits de débit coeur. Le signal restitué $r^{B+k1}(n)$ issu de ce décodage bénéficiera d'une qualité améliorée grâce aux étages de codage d'amélioration mis en oeuvre dans le codeur.

Pour un canal de transmission à débit plus élevé, 80, 96 kbit/s, si le train binaire $I^{B+k1+k2}(n)$ a un débit supérieur au débit du décodeur standard 700 et indiqué par l'indicateur de mode 740, un décodeur additionnel 730 effectue alors une quantification inverse de $I^{B+k1+k2}(n)$, en plus des quantifications inverses à B+1 et B+2 bits décrites en référence à la figure 2 pour fournir l'erreur quantifiée qui additionnée au signal de prédiction $x_P^B(n)$ donnera le signal amélioré haut débit $r^{B+k1+k2}(n)$.

Un premier mode de réalisation d'un codeur selon l'invention est maintenant décrit en référence à la **figure 8**. Dans ce mode de réalisation, l'étage de codage de débit coeur 800 effectue un codage de type MICDA avec une mise en forme du bruit de codage.

L'étage de codage coeur comporte un module 810 de calcul de la prédiction du signal $x_P^B(n)$ réalisée à partir des échantillons précédents du signal d'erreur quantifié $e_Q^B(n') = y_{I^B}^B(n')v(n') \quad n' = n - 1,..., n - N_Z$ via l'indice bas débit $I^B(n)$ de la couche coeur et du signal reconstitué $r^B(n') \quad n' = n - 1,... n - N_P$ comme celui décrit en référence à la figure 1.

Un module de soustraction 801 de la prédiction $x_P^B(n)$ au signal d'entrée $x(n)$ est prévu pour obtenir un signal d'erreur de prédiction $d_P^B(n)$.

Le codeur coeur comporte également un module 802 de prédiction $P_r(z)$ de bruit $p_R^{BK_M}(n)$ réalisée à partir des échantillons du bruit de quantification précédents $q^B(n')$ $n' = n - n - N_{NH}$ et du bruit filtré $q_f^{BK_M}(n')$ $n' = n-1,...,n-N_{DH}$.

Un module d'addition 803 de la prédiction de bruit $p_R^{BK_M}(n)$ au signal d'erreur de prédiction $d_P^B(n)$ est également prévu pour obtenir un signal d'erreur noté $e^B(n)$.

Un module 820 de quantification de coeur $Q^B$ reçoit en entrée le signal d'erreur $e^B(n)$ pour donner des indices de quantification $I^B(n)$. L'indice de quantification optimal $I^B(n)$ et la valeur quantifiée $y_{I^B(n)}^B(n)v(n)$ minimisent le critère d'erreur $E_j^B = \left[ e^B(n) - y_j^B(n)v(n) \right]^2$ $j = 0,...,N_Q - 1$ où les valeurs $y_j^B(n)$ sont les niveaux reconstruits et $v(n)$ le facteur d'échelle issu du module 804 d'adaptation du quantificateur.

A titre d'exemple pour le codeur G.722, les niveaux de reconstruction du quantificateur de coeur $Q^B$ sont définis par le tableau VI de l'article de X. Maitre. "7 kHz audio coding within 64 kbit/s", IEEE Journal on Selected Areas in Communication, Vol.6-2, February 1988".

L'indice de quantification $I^B(n)$ de B bits en sortie du module de quantification $Q^B$ sera multiplexé dans le module de multiplexage 830 avec les bits d'amélioration $J_1,..., J_K$ avant d'être transmis via le canal de transmission 840 au décodeur tel que décrit en référence à la figure 7.

L'étage de codage coeur comporte également un module 805 de calcul du bruit de quantification, différence entre l'entrée du quantificateur et sa sortie $q_Q^B(n) = e_Q^B(n) - e^B(n)$, un module 806 de calcul du bruit de quantification filtré par addition du bruit de quantification à la prédiction du bruit de quantification $q_f^{BK_M}(n) = q^B(n) + p_R^{BK_M}(n)$ et un module 807 de calcul du signal reconstruit en ajoutant la prédiction du signal à l'erreur quantifiée $r^B(n) = e_Q^B(n) + x_P^B(n)$

Le module 804 d'adaptation $Q_{Adapt}^B$ du quantificateur $Q^B$ donne un paramètre de contrôle de niveau $v(n)$ encore appelé facteur d'échelle pour l'instant suivant $n+1$.

Le module de prédiction 810 comporte un module 811 d'adaptation $P_{Adapt}$ à partir des échantillons du signal d'erreur quantifié reconstruit $e_Q^B(n)$ et éventuellement du signal d'erreur quantifié reconstruit $e_Q^B(n)$ filtré par $1+P_Z(z)$.

Le module 850 *Calc Mask* détaillé ultérieurement est prévu pour fournir le filtre de mise en forme du bruit de codage qui peut être utilisé à la fois par l'étage de codage coeur et les étages de codage d'amélioration, soit à partir du signal d'entrée, soit à partir du signal localement décodé par le codage coeur (au débit coeur), soit à partir des coefficients du filtre de prédiction calculés dans le codage MICDA par un algorithme du gradient simplifié. Dans le dernier cas, le filtre de mise en forme du bruit peut être obtenu à partir de coefficients d'un filtre de prédiction utilisé pour le codage de débit coeur, par adjonction de constantes d'amortissement et adjonction d'un filtre de dé-emphase.

Il est également possible d'utiliser le module de masquage uniquement dans les étages d'amélioration ; cette alternative est avantageuse dans le cas où le codage coeur utilise peu de bits par échantillon, auquel cas l'erreur de codage n'est pas un bruit blanc et le rapport signal à bruit est très faible - cette situation se retrouve dans le codage MICDA à 2 bits par échantillon de la bande haute (4000-8000 Hz) dans la norme G.722, dans ce cas la mise en forme de bruit par rétroaction n'est pas efficace.

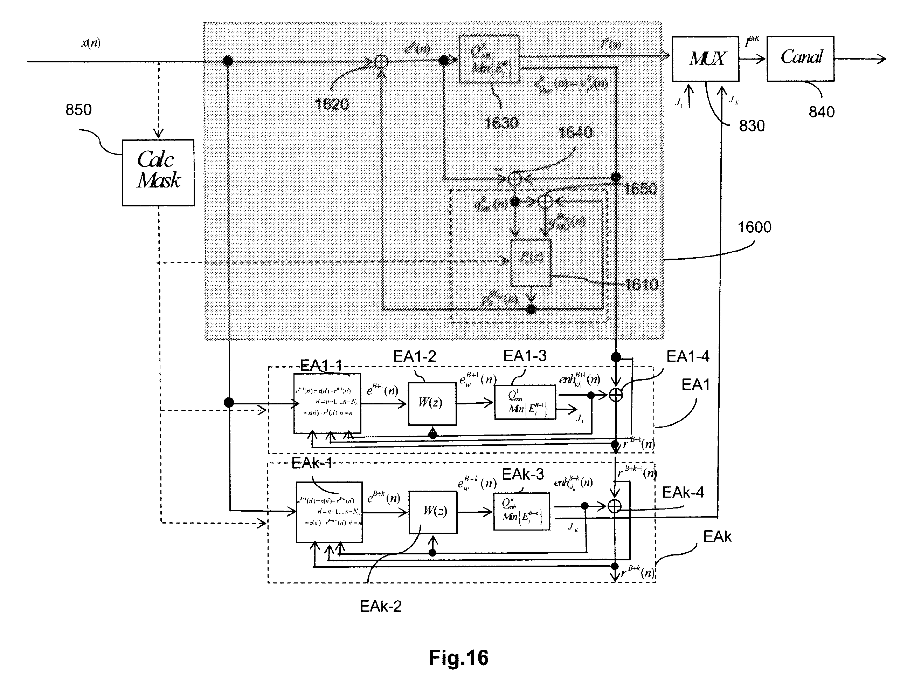

A noter que la mise en forme de bruit du codage coeur, correspondant aux blocs 802, 803, 805, 806 à la figure 8, est optionnelle. L'invention telle que représentée à la figure 16 s'applique même pour un codage coeur MICDA réduit aux blocs 801, 804, 807, 810, 811, 820.

La **figure 9** décrit de façon plus détaillée le module 802 effectuant le calcul de la prédiction du bruit de quantification $P_R^{BK_M}(z)$ par un filtre ARMA (pour "AutoRegressif à Moyenne Ajustée" d'expression générale :

$$H^M(z) = \frac{1 - P_N^M(z)}{1 - P_D^M(z)} \qquad (6)$$

Par souci de simplification, on utilise ici les notations de la transformée en z.

Afin d'obtenir une mise en forme du bruit qui puisse tenir compte, à la fois, des caractéristiques à court-terme et à long-terme des signaux audiofréquences, le filtre $H^M(z)$ est représenté par des cellules 900, 901, 902 de filtrage ARMA en cascade:

$$H^M(z) = \prod_{j=1}^{K_M} F^j(z) = \prod_{j=1}^{K_M} \frac{1 - P_N^j(z)}{1 - P_D^j(z)} \qquad (7)$$

Le bruit de quantification filtré $Q_f^{BK_M}(z)$ de la figure 9, à l'issu de cette cascade de filtre, sera donné en fonction du bruit de quantification $Q^B(z)$ par :

$$Q_f^{BK_M}(z) = \prod_{j=1}^{K_M} \frac{1 - P_N^j(z)}{1 - P_D^j(z)} Q^B(z) \qquad (8)$$

La **figure 10** montre de façon plus détaillée un module $F^k(z)$ 901. Le bruit de quantification en sortie de cette cellule k est donné par :

$$Q_f^k(z) = Q_f^{k-1}(z) - P_N^k(z)Q_f^{k-1}(z) + P_D^k(z)Q_f^k(z) \qquad (9)$$

En itérant de $k = 1,..., K_M$, il vient :

$$Q_f^{BK_M}(z) = Q^B(z) + \sum_{k=1}^{K_M} P_D^k(z)Q_f^k(z) - P_N^k(z)Q_f^{k-1}(z) \qquad (10)$$

Soit :

$$Q_f^{BK_M}(z) = Q^B(z) + P_R^{BK_M}(z) \qquad (11)$$

Avec la prédiction du bruit $P_R^{BK_M}(z)$ donnée par :

$$P_R^{BK_M}(z) = \sum_{k=1}^{K_M} P_D^k(z)Q_f^k(z) - P_N^k(z)Q_f^{k-1}(z) \qquad (12)$$

On vérifie ainsi aisément que la mise en forme du bruit de codage de coeur par la figure 8 est effective par les équations suivantes:

$$E^B(z) = X(z) - X_P^B(z) + P_R^{BK_M}(z) \qquad (13)$$

$$Q^B(z) = E_Q(z) - E^B(z) \qquad (14)$$

$$R^B(z) = E_Q(z) + X_P^B(z) \qquad (15)$$

D'où:

$$R^B(z) = X(z) + Q_f^{BK_M}(z) \qquad (16)$$

$$R^B(z) = X(z) + \prod_{j=1}^{K_M} \frac{1 - P_N^j(z)}{1 - P_D^j(z)} Q^B(z) \qquad (17)$$

Comme le bruit de quantification est à peu près blanc, le spectre du bruit de codage perçu est mis en forme par le filtre $H^M(z) = \prod_{j=1}^{K_M} \frac{1 - P_N^j(z)}{1 - P_D^j(z)}$, donc moins audible.

Comme décrit par la suite une cellule de filtrage ARMA pourra être déduite d'un filtre inverse de prédiction linéaire du signal d'entrée $A_g(z) = 1 - \sum_{k=1}^{K} a_g(k)z^{-k}$ en affectant des coefficients g$_1$ et g$_2$ de la façon suivante:

$$\frac{1 - P_N^j(z)}{1 - P_D^j(z)} = \frac{A_{g1}(z)}{A_{g2}(z)} = \frac{1 - \sum_{k=1}^{N_j} a_g(k)g_1^k z^{-k}}{1 - \sum_{k=1}^{D_j} a_g(k)g_2^k z^{-k}} \qquad (18)$$

Ce type de fonction de pondération comportant une valeur au numérateur et une valeur au dénominateur a l'avantage par la valeur au dénominateur de prendre en compte les pics de signal et par la valeur au numérateur d'atténuer ces pics apportant ainsi une mise en forme optimale du bruit de quantification. Les valeurs de g$_1$ et g$_2$ sont telles que:

$$1 > g_2 > g_1 > 0$$

La valeur particulière g$_1$ = 0 donne un filtre de masquage purement autorégressif et celle de g$_2$ = 0 donne un filtre MA à moyenne ajustée.

De plus, dans le cas des signaux voisés et celui des signaux audionumériques de haute fidélité, une légère mise en forme à partir de la structure fine du signal révélant les périodicités du signal, réduit le bruit de quantification perçu entre les harmoniques du signal. L'amélioration est particulièrement significative dans le cas des signaux à fréquence fondamentale ou pitch relativement élevée par exemple supérieure à 200 Hz.

Une cellule ARMA de mise en forme à long-terme du bruit est donnée par :

$$\frac{1 - P_N^j(z)}{1 - P_D^j(z)} = \frac{1 - \sum_{k=-M_P}^{M_P} p_{2M_P}(k)z^{-(Pitch+k)}}{1 - \sum_{k=-M_P}^{M_P} p_{1M_P}(k)z^{-(Pitch+k)}} \qquad (19)$$

En revenant à la description de la figure 8, le codeur comprend également plusieurs étages de codage d'amélioration. Deux étages EA1 et EAk sont ici représentés.

L'étage de codage d'amélioration EAk permet d'obtenir le bit d'amélioration $J_k$ ou un groupe de bits $J_k$k = 1, $G_K$ et est tel que décrit en référence aux figures 6a et 6b.

Cet étage de codage comprend un module EAk-1 de soustraction au signal d'entrée $x(n)$ du signal $r^{B+k}(n)$ formé du signal synthétisé à l'étage k $r^{B+k}(n)$ pour les instants d'échantillonnage $n - 1,..., n - N_D$ et du signal $r^{B+k-1}(n)$ synthétisé à l'étage k-1 pour l'instant n, pour donner un signal d'erreur de codage $e^{B+k}(n)$

Un module de filtrage EAk-2 de $e^{B+k}(n)$ par la fonction de pondération $W(z)$ est également compris dans l'étage de codage k. Cette fonction de pondération est égale à l'inverse du filtre de masquage $H^M(z)$ donné par le codage coeur tel que décrit précédemment. A la sortie du module EAk-2, un signal filtré $e_w^{B+k}(n)$ est obtenu.

L'étage de codage d'amélioration k comprend un module EAk-3 de minimisation du critère d'erreur $E_j^{B+k}$ pour

$j = 0,1$ réalisant une quantification d'amélioration $Q_{enh}^{k}$ ayant pour première sortie la valeur du bit optimal $J_k$ à concaténer à l'indice de l'étage précédent $I^{B+k-1}$ et pour deuxième sortie $enh_{VCJ_k}^{B+k}(n) = enh_{2I^{B+k-1}+J_k}^{B+k}(n)v(n)$, le signal de sortie du quantificateur pour l'indice optimal $J_k$.

L'étage k comporte aussi un module d'addition EAk-4 du signal d'erreur quantifiée $enh_{2I^{B+k-1}+J_k}^{B+k}(n)v(n)$ au signal synthétisé à l'étage précédent $r^{B+k-1}(n)$ pour donner le signal synthétisé à l'étage k $r^{B+k}(n)$.

Dans le cas d'un seul filtre ARMA de mise en forme, le signal d'erreur filtré est alors donné en notation en transformée z, par:

$$E_W(z) = W^1(z)E(z) = \frac{1 - P_D(z)}{1 - P_N(z)} E(z) \qquad (20)$$

Ainsi, pour chaque instant d'échantillonnage n, on calcule un signal reconstitué partiel $r^{B+k}(n)$ à partir du signal reconstruit à l'étage précédent $r^{B+k-1}(n)$ et des échantillons passés du signal $r^{B+k}(n)$.

Ce signal est soustrait du signal $x(n)$ pour donner le signal d'erreur $e^{B+k}(n)$.

Le signal d'erreur est filtré par le filtre ayant une cellule ARMA de filtrage $W^1$ pour donner:

$$e_w^{B+k}(n) = e^{B+k}(n) - \sum_{k=1}^{N_D} p_D(k)e^{B+k}(n-k) + \sum_{k=1}^{N_N} p_N(k)e_w^{B+k}(n-k) \qquad (21)$$

Le critère d'erreur pondérée revient à minimiser l'erreur quadratique pour les deux valeurs (ou $N_G$ valeurs si plusieurs bits) de sorties possibles du quantificateur :

$$E_j^{B+k} = \left[ e_w^{B+k}(n) - enh_{VCj}^{B+k}(n) \right]^2 \quad j = 0,1 \qquad (22)$$

Cette étape de minimisation donne l'indice optimal $J_k$ et la valeur quantifiée pour l'indice optimal $enh_{VCJ_k}^{B+k}(n) = enh_{2I^{B+k-1}+J_k}^{B+k}(n)v(n)$, encore noté $enh_{vJ_k}^{B+k}(n)v(n)$.

Dans le cas où le filtre de masquage est constitué de plusieurs cellules ARMA en cascade, on effectue des filtrages en cascade.

Par exemple, pour une cellule de filtrage à court-terme et de pitch en cascade on aura :

$$E_w^{B+k}(z) = \frac{1 - \sum_{k=1}^{N_D} p_D(k)z^{-k}}{1 - \sum_{k=1}^{N_N} p_N(k)z^{-k}} \frac{1 - \sum_{k=-M_P}^{M_P} p_{2M_P}(k)z^{-(Pitch+k)}}{1 - \sum_{k=-M_P}^{M_P} p_{1M_P}(k)z^{-(Pitch+k)}} E^{B+k}(z) \qquad (23)$$

La sortie de la première cellule de filtrage sera égale à :

$$e_{1w}^{B+k}(n) = e^{B+k}(n) - \sum_{k=1}^{N_D} p_D(k)e^{B+k}(n-k) + \sum_{k=1}^{N_N} p_N(k)e_{1w}^{B+k}(n-k) \qquad (24)$$

Et celle de la deuxième cellule :

$$e_{2w}^{B+k}(n) = e_{1w}^{B+k}(n) - \sum_{k=-M_P}^{k=M_P} p_{2M_P}(k)e_{1w}^{B+k}(n-Pitch+k) + \sum_{k=-M_P}^{k=M_P} p_{1M_P}(k)e_{2w}^{B+k}(n-Pitch+k)$$

$$(25)$$

Une fois que $enh_{v,J_k}^{B+k}(n)v(n)$ est obtenu par minimisation du critère, $e^{B+k}(n)$ est adapté en retranchant $enh_{v,J_k}^{B+k}(n)v(n)$ de $e^{B+k}(n)$ puis la mémoire de stockage est décalée vers la gauche et la valeur $r^{B+k+1}(n+1)$ est entrée en position la plus récente pour l'instant suivant $n$+1.

On adapte ensuite les mémoires du filtre par :

$$e_{1w'}^{B+k}(n) = e_{1w'}^{B+k}(n) - enh_{v,J_k}^{B+k}(n)v(n) \quad (28)$$

$$e_{2w'}^{B+k}(n) = e_{2w'}^{B+k}(n) - enh_{v,J_k}^{B+k}(n)v(n) \quad (29)$$

La procédure précédente est itérée dans le cas général où

$$E_w^{B+k}(z) = \prod_{j=1}^{K_M} \frac{1-P_N^j(z)}{1-P_D^j(z)} E^{B+k}(z) \quad\quad (30)$$

Ainsi, les bits d'amélioration sont obtenus bit par bit ou groupe de bits par groupe de bits dans des étages d'amélioration en cascade.

Contrairement à l'état de l'art où les bits de coeur du codeur et ceux d'amélioration sont obtenus directement en quantifiant le signal d'erreur $e(n)$ comme représenté en figure 1, les bits d'amélioration selon l'invention sont calculés de telle sorte que le signal d'amélioration en sortie du décodeur standard soit reconstruit avec une mise en forme du bruit de quantification.

Connaissant l'indice $I^B(n)$ obtenu en sortie du quantificateur de coeur et du fait que le quantificateur de type MICDA à B+1 bits est à codes imbriqués, seules deux valeurs de sorties sont possibles pour le quantificateur à B+1 bits.

Le même raisonnement s'applique pour la sortie de l'étage d'amélioration à B+k bits en fonction de l'étage d'amélioration à B+k-1 bits.

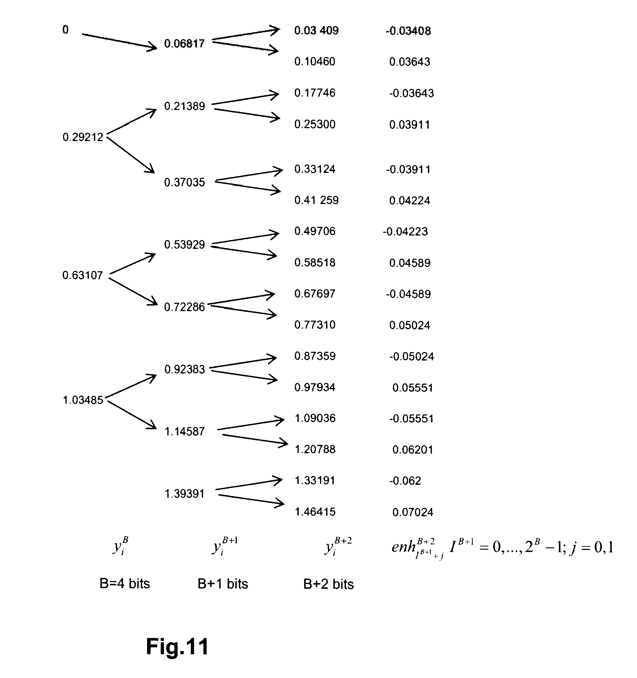

La **figure 11** représente les 4 premiers niveaux du quantificateur de coeur à B bits pour B=4 bits et les niveaux des quantificateurs à B+1 et B+2 bits du codage de la bande basse d'un codeur G.722 ainsi que les valeurs de sortie du quantificateur d'amélioration pour B+2 bits.

Comme illustré sur cette figure, le quantificateur imbriqué à B+1=5 bits est obtenu en dédoublant les niveaux du quantificateur à B=4 bits. Le quantificateur imbriqué à B+2=6 bits est obtenu en dédoublant les niveaux du quantificateur à B+1=5 bits.

Dans un mode de réalisation de l'invention, les valeurs désignant des niveaux de reconstructions de quantification pour un étage d'amélioration k sont définis par la différence entre les valeurs désignant les niveaux de reconstruction de la quantification d'un quantificateur imbriqué à B+k bits, B désignant le nombre de bits du codage coeur et les valeurs désignant les niveaux de reconstruction de quantification d'un quantificateur imbriqué à B+k-1 bits, les niveaux de reconstruction du quantificateur imbriqué à B+k bits étant définis par dédoublement des niveaux de reconstruction du quantificateur imbriqué à B+k-1 bits.

On a donc la relation suivante:

$$y_{2I^{B+k-1}+j}^{B+k} = y_{I^{B+k-1}}^{B+k-1} + enh_{2I^{B+k-1}+j}^{B+k} \quad k=1,...,K; j=0,1 \quad\quad (31)$$

$y_{2I^{B+k-1}+j}^{B+k}$ représentant les niveaux de reconstruction possibles d'un quantificateur imbriqué à B+k bits, $y_{I^{B+k-1}}^{B+k-1}$ représentant les niveaux de reconstruction du quantificateur imbriqué à B+k-1 bits et $enh_{2I^{B+k-1}+j}^{B+k}$ représentant le terme d'amélioration ou niveau de reconstruction pour l'étage k. A titre d'exemple, les niveaux en sortie de l'étage k=2, c'est-à-dire pour B+k=6 sont donnés sur la figure 11 en fonction du quantificateur imbriqué pour B+k= 5 bits.

Les sorties possibles du quantificateur à B+k bits sont données par :

$$e_{Q2I^{B+k-1}+j}^{B+k} = y_{I^{B+k-1}}^{B+k-1}v(n) + enh_{2I^{B+k-1}+j}^{B+k}v(n) \quad k=1,...,K; j=0,1 \quad\quad (32)$$

$v(n)$ représentant le facteur d'échelle défini par le codage coeur pour adapter le niveau de sortie des quantificateurs fixes.

Avec la méthode de l'état de l'art, la quantification pour les quantificateurs à B, B+1, ...,B+K bits était effectuée en une seule fois en repérant dans quelle plage de décision du quantificateur à B+K bits se trouve la valeur $e(n)$ à quantifier.

La présente invention propose une méthode différente. Connaissant la valeur quantifiée issue du quantificateur à B+k-1 bits, la quantification du signal $e_w^{B+k}(n)$ à l'entrée du quantificateur est faite en minimisant l'erreur de quantification et sans faire appel aux seuils de décision, ce qui permet avantageusement de réduire le bruit de calcul pour une implantation à virgule fixe du produit $enh_{2I^{B+k-1}+j}^{B+k}\,v(n)$ tel que:

$$E_j^{B+k} = \left[ \left( e_w^{B+k}(n) - y_{I^{B+k-1}}^{B+k-1}\,v(n) - enh_{2I^{B+k-1}+j}^{B+k}\,v(n) \right) \right]^2 \quad j=0,1 \qquad (33)$$

Plutôt que de minimiser un critère d'erreur quadratique qui va engendrer un bruit de quantification à spectre plat comme représenté en référence à la figure 4, on va minimiser un critère d'erreur quadratique pondéré, afin que le bruit mis en forme spectralement soit moins audible.

La fonction de pondération spectrale utilisée est $W(z)$, qui peut être également utilisée pour la mise en forme du bruit dans l'étage de codage coeur.

En revenant à la description de la figure 8, on voit que le signal restitué de coeur est égal à la somme de la prédiction et de la sortie du quantificateur inverse, c'est à dire :

$$r^B(n) = x_P^B(n) + y_{I^B}^B\,v(n) \qquad (34)$$

Du fait que la prédiction du signal est effectuée à partir du codeur MICDA de coeur, les deux signaux reconstitués possibles à l'étage k sont donnés en fonction du signal effectivement reconstitué à l'étage k-1 par l'équation suivante :

$$r_j^{B+k} = x_P^B(n) + y_{I^{B+k-1}}^{B+k-1}\,v(n) + enh_{2I^{B+k-1}+j}^{B+k}\,v(n) \qquad (35)$$

On en déduit le critère d'erreur à minimiser à l'étage k :

$$E_j^{B+k} = \left[ x(n) - x_P^B(n) - y_{I^{B+k-1}}^{B+k-1}\,v(n) - enh_{2I^{B+k-1}+j}^{B+k}\,v(n) \right]^2 \quad j=0,1 \qquad (36)$$

Soit :

$$E_j^{B+k} = \left[ \left( x(n) - r^{B+k-1}(n) \right) - enh_{2I^{B+k-1}+j}^{B+k}\,v(n) \right]^2 \quad j=0,1 \qquad (37)$$

Plutôt que de minimiser un critère d'erreur quadratique qui va engendrer un bruit de quantification à spectre plat comme décrit précédemment, on va minimiser un critère d'erreur quadratique pondéré, comme pour le codage coeur, afin que le bruit mis en forme spectralement soit moins audible. La fonction de pondération spectrale utilisée est $W(z)$, celle déjà utilisée pour le codage de coeur dans l'exemple donné - il est cependant possible d'utiliser cette fonction de pondération uniquement dans les étages d'amélioration.

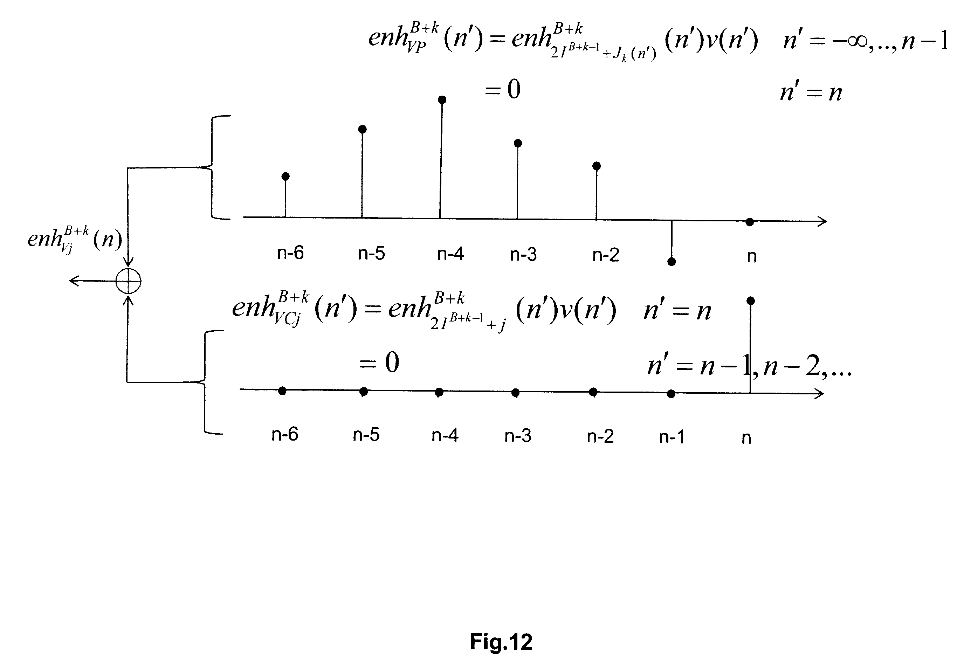

Conformément à la **figure 12** on définit le signal $enh_{Vj}^{B+k}(n')$ comme étant égal à la somme des deux signaux :

$enh_{VP}^{B+k}(n')$ représentant la concaténation de toutes les valeurs $enh_{2I^{B+k-1}+J_k(n')}^{B+k}(n')v(n')$ pour $n' < n$ et égal à 0 pour $n' = n$

et $enh_{VCj}^{B+k}(n')$ égal à $enh_{2I^{B+k-1}+j}^{B+k}(n')v(n')$ pour $n = n$ et nul pour $n' < n$.

Le critère d'erreur, plus facile à interpréter dans le domaine de la transformée en z est alors donné par l'expression suivante :

$$E_j^{B+k} = \frac{1}{2\pi j}\oint_C \left| \left[ (X(z) - R^{B+k-1}(z)) - Enh_{Vj}^{B+k}(z) \right] W(z) \right|^2 \quad j = 0,1 \qquad (38)$$

Où $Enh_{Vj}^{B+k}(z)$ est la transformée en z de $enh_{Vj}^{B+k}(n)$.

En décomposant $Enh_{Vj}^{B+k}(z)$, on obtient :

$$E_j^{B+k} = \frac{1}{2\pi j}\oint_C \left| \left\{ X(z) - \left[ R^{B+k-1}(z) + Enh_{VP}^{B+k}(z) \right] \right\} W(z) - Enh_{VCj}^{B+k}(z) \right|^2 \quad j = 0,1 \qquad (39)$$

Par exemple, pour minimiser ce critère on commence par calculer le signal :

$$R_P^{B+k}(z) = R^{B+k-1}(z) + Enh_{VP}^{B+k}(z) \qquad (40)$$

avec $enh_{VP}^{B+k}(n) = 0$ puisqu'on ne connaît pas encore la valeur quantifiée. La somme du signal de l'étage précédent et de $enh_{VP}^{B+k}(n)$ est égale au signal reconstitué de l'étage k. $R_P^{B+k}(z)$, est donc la transformée en z du signal égal à $r^{B+k}(n')$ pour $n' < n$ et égal à $r^{B+k-1}(n')$ pour $n' = n$ tel que:

$$r_P^{B+k}(n') = r^{B+k}(n') \quad n' = n-1,...,n-N_D$$
$$= r^{B+k-1}(n') \quad n' = n$$

Pour l'implantation sur processeur, on ne calculera généralement pas explicitement le signal $r^{B+k}(n)$, mais on calculera avantageusement le signal d'erreur $e^{B+k}(n)$, différence entre $x(n)$ et $r^{B+k}(n)$ :

$$e^{B+k}(n') = x(n') - r^{B+k}(n') \quad n' = n-1,...,n-N_D$$
$$= x(n') - r^{B+k-1}(n') \quad n' = n \qquad (41)$$

$e^{B+k}(n)$ est formé à partir de $r^{B+k-1}(n)$ et de $r^{B+k}(n)$ et le nombre d'échantillons à garder en mémoire pour le filtrage qui va suivre est de $N_D$ échantillons, le nombre de coefficients du dénominateur du filtre de masquage.

Le signal d'erreur filtré $E_w^{B+k}(z)$ sera égal à :

$$E_w^{B+k}(z) = E^{B+k}(z)W(z) \qquad (42)$$

On en déduit le critère d'erreur quadratique pondéré :

$$E_j^{B+k} = \left[ e_w^{B+k}(n) - enh_{VCj}^{B+k}(n) \right]^2 \qquad (43)$$

L'indice optimal $J_k$ est celui qui minimise le critère $E_j^{B+k}$ pour j = 0,1 réalisant ainsi la quantification scalaire $Q_{enh}^k$ à partir des deux niveaux d'amélioration $enh_{VCj}^{B+k}(n) \quad j = 0,1$ calculés à partir des niveaux de reconstruction du quantificateur scalaire à B + k bits et connaissant l'indice optimal de coeur et les indices $J_i$ i = 1,..., k-1 ou de façon équivalente $I^{B+k-1}$.

La valeur de sortie du quantificateur pour l'indice optimal est égale à:

$$enh_{VCJ_k}^{B+k}(n) = enh_{2I^{B+k-1}+J_k}^{B+k}(n)v(n) \qquad (44)$$

et la valeur du signal reconstitué à l'instant n sera donnée par :

$$r^{B+k}(n) = r^{B+k-1}(n) + enh_{2I^{B+k-1}+J_k}^{B+k}(n)v(n) \qquad (45)$$

Connaissant la sortie quantifiée $enh_{VCJ_k}^{B+k}(n) = enh_{2I^{B+k-1}+J_k}^{B+k}(n)v(n)$ , on met à jour le signal de différence $e^{B+k}(n)$ pour l'instant d'échantillonnage $n$ :

$$e^{B+k}(n) \leftarrow e^{B+k}(n) - enh_{2I^{B+k-1}+J_k}^{B+k}(n)v(n)$$

Et on adapte les mémoires du filtre.
On incrémente n d'une unité. On s'aperçoit alors que le calcul de $e^{B+k}(n)$ est extrêmement simple : il suffit de laisser tomber l'échantillon le plus ancien en décalant la mémoire de stockage de $e^{B+k}(n)$ d'une case vers la gauche et d'insérer comme échantillon le plus récent $r^{B+k-1}(n+1)$, la valeur quantifiée n'étant pas encore connue. Le décalage de la mémoire peut être évité en utilisant judicieusement les pointeurs.
Les figures 13 et 14 illustrent deux modes de réalisation de calcul de filtre de masquage mis en oeuvre par le module 850 de calcul du filtre de masquage.
Dans un premier mode de réalisation illustré en **figure 13**, un bloc courant de signal qui correspond au bloc de la trame courante complété par un segment d'échantillon de la trame précédente $S(n)$, $n = -N_s,....,-1,0,..., N_r$ est pris en compte.
Pour mieux faire ressortir les pics du spectre du filtre de masquage, le signal est pré-traité (traitement de pré-emphase) avant le calcul en E60 des coefficients de corrélation par un filtre $A_1(z)$ dont le ou les coefficients sont soit fixes soit adaptés par prédiction linéaire comme décrit dans le brevet FR2742568.
Dans le cas où une pré-emphase est utilisée le signal à analyser $S_p(n)$ est calculé par filtrage inverse :

$$S_P(z) = A_1(z)S(z).$$

Le bloc de signal est ensuite pondéré en E 61 par une fenêtre de Hanning ou une fenêtre formée de la concaténation de sous-fenêtres, comme connu de l'état de l'art.
Les $K_{c2} + 1$ coefficients de corrélation sont ensuite calculés en E62 par:

$$Cor(k) = \sum_{n=0}^{N-1} s_p(n)s_p(n-k) \; k = 0,..., K_{c2} \qquad (46)$$

Les coefficients du filtre AR (pour AutoRegressif) $A_2(z)$ qui modélise l'enveloppe du signal pré-emphasé sont donnés en E63 par l'algorithme de Levinson-Durbin.

On obtient donc un filtre $A(z)$ en E64, filtre de fonction de transfert $\dfrac{1}{A(z)} = \dfrac{1}{1-A_1(z)}\dfrac{1}{1-A_2(z)}$ modélisant l'enveloppe du signal d'entrée.
Lorsque l'on met en oeuvre ce calcul pour les deux filtres $1 - A_1(z)$ et $1 - A_2(z)$, du codeur selon l'invention, on obtient ainsi en E65 un filtre de mise en forme donné par:

$$H^M(z) = \frac{1-P_{N1}(z)}{1-P_{D1}(z)}\frac{1-P_{N2}(z)}{1-P_{D2}(z)} = \frac{1-\sum_{k=1}^{K_{c1}}a_1(k)g_{N1}^k z^{-k}}{1-\sum_{k=1}^{K_{c1}}a_1(k)g_{D1}^k z^{-k}}\frac{1-\sum_{k=1}^{K_{c2}}a_2(k)g_{N2}^k z^{-k}}{1-\sum_{k=1}^{K_{c2}}a_2(k)g_{D2}^k z^{-k}} \qquad (47)$$

Les constantes $g_{N1}$, $g_{D1}$, $g_{N2}$ et $g_{D2}$ permettent d'ajuster le spectre du filtre de masquage notamment les deux premières qui règlent la pente du spectre du filtre.

On obtient ainsi un filtre de masquage formé de la mise en cascade de deux filtres où les filtres de pente et de formants ont été découplés. Cette modélisation où chaque filtre est adapté en fonction des caractéristiques spectrales du signal d'entrée est particulièrement adaptée aux signaux présentant tout type de pente spectrale. Dans le cas où $g_{N1}$ et $g_{N2}$ sont nuls on obtient un filtrage de masquage cascade de deux filtres autorégressifs qui suffisent en première approximation.

Un deuxième exemple de mise en oeuvre du filtre de masquage, de faible complexité, est illustré en référence à la **figure 14**.

Le principe ici est d'utiliser directement le filtre de synthèse du filtre ARMA de reconstruction du signal décodé avec une désaccentuation appliquée par un filtre de compensation fonction de la pente du signal d'entrée.

L'expression du filtre de masquage est donnée par :

$$H^M(z) = \frac{1 - P_z(z/g_{z1})}{1 - P_P(z/g_{z2})}\left[1 - P_{Com}(z)\right] \qquad (48)$$

Dans les normes G.722, G.726 et G.727 le prédicteur ARMA MICDA possède 2 coefficients au dénominateur. Dans ce cas le filtre de compensation calculé en E71 sera de la forme :

$$1 - P_{Com}(z) = 1 - \sum_{i=1}^{2} p_P(i)g_{Com}^i z^{-i} \qquad (49)$$

Et les filtres $P_z(z)$ et $P_p(z)$ donnés en E70 seront remplacés par leur version bridée par des constantes d'amortissement $g_{Z1}$ et $g_{P1}$ données en E72, pour donner un filtre de mise en forme du bruit de la forme :

$$H^M(z) = \frac{1 + \sum_{i=1}^{N_Z} p_Z(i)g_{Z1}^i z^{-i}}{1 - \sum_{i=1}^{N_P} p_P(i)g_{P1}^i z^{-i})}\left[1 - \sum_{i=1}^{2} p_{Com}(i)g_{Com}^i z^{-i}\right] \qquad (50)$$

En prenant :

$$p_{Com}(i) = 0 \quad i = 1,2$$

On obtient une forme simplifiée du filtre de masquage constituée d'une cellule ARMA.

Une autre forme très simple de filtre de masquage est celle obtenue en ne prenant que le dénominateur du prédicteur ARMA avec un léger amortissement :

$$H^M(z) = \frac{1}{1 - P_P(z/g_P)} \qquad (51)$$

avec par exemple $g_P = 0{,}92$.

Ce filtre AR de reconstruction partielle du signal conduit à une complexité réduite.

Dans une forme particulière de réalisation et pour éviter d'adapter les filtres à chaque instant d'échantillonnage on pourra figer les coefficients du filtre à amortir sur une trame de signal ou plusieurs fois par trame pour conserver un effet de lissage.

Une façon d'effectuer le lissage est de détecter les brusques variations de dynamique sur le signal à l'entrée du quantificateur ou de façon équivalente mais de complexité minimale directement sur les indices en sortie du quantificateur. Entre deux variations brusques d'indices on obtient une zone où les caractéristiques spectrales sont moins fluctuantes, et donc avec des coefficients MICDA plus adaptés en vue du masquage.

Le calcul des coefficients des cellules de mise en forme à long-terme du bruit de quantification

$$F^j(z) = \frac{1 - \displaystyle\sum_{k=-M_P}^{M_P} p_{2M_P}(k) z^{-(Pitch+k)}}{1 - \displaystyle\sum_{k=-M_P}^{M_P} p_{1M_P}(k) z^{-(Pitch+k)}} \qquad (52)$$

est effectué à partir du signal d'entrée du quantificateur qui contient une composante périodique pour les sons voisés. On peut noter que la mise en forme du bruit à long-terme est importante si l'on veut obtenir une amélioration de qualité appréciable pour les signaux périodiques, en particuliers les signaux de parole voisés. C'est en fait la seule façon de prendre en compte la périodicité des signaux périodiques pour les codeurs dont le modèle de synthèse ne comporte pas de prédicteur à long-terme.

La période de pitch est calculée, par exemple, en minimisant l'erreur quadratique de prédiction à long-terme à l'entrée $e^B(n)$ du quantificateur $Q^B$ de la figure 8, en maximisant le coefficient de corrélation:

$$Cor(i)^2 = \frac{\left(\displaystyle\sum_{n=-1}^{-N_P} e^B(n) e^B(n-i)\right)^2}{\displaystyle\sum_{n=-1}^{-N_P} e^B(n)^2 \sum_{n=-1}^{-N_P} e^B(n-i)^2} \quad i = P_{Min},...,P_{Max} \qquad (53)$$

*Pitch* est tel que :

$$Cor(Pitch) = Max\{Cor(i)\} \ i = P_{Min},...,P_{Max}$$

Le gain de prédiction de pitch $Cor_f(i)$ utilisé pour générer les filtres de masquage est donné par:

$$Cor_f(Pitch+i) = \frac{\displaystyle\sum_{n=-1}^{-N_P} e^B(n) e^B(n-Pitch+i)}{\sqrt{\displaystyle\sum_{n=-1}^{-N_P} e^B(n)^2 \sum_{n=-1}^{-N_P} e^B(n-Pitch+i)^2}}$$

Les coefficients du filtre de masquage à long-terme seront donnés par :

$$p_{2M_P}(i) = g_{2Pitch} Cor_f(Pitch+i) \ i = -M_P,...,M_P$$

Et

$$p_{1M_P}(i) = g_{1Pitch} Cor_f(Pitch+i) \qquad i = -M_P,...,M_P$$

Une méthode de réduction de la complexité de calcul de la valeur du pitch est décrite par la Figure 8-4 de la norme UIT-T G.711.1 «Wideband embedded extension for G.711 pulse code modulation »

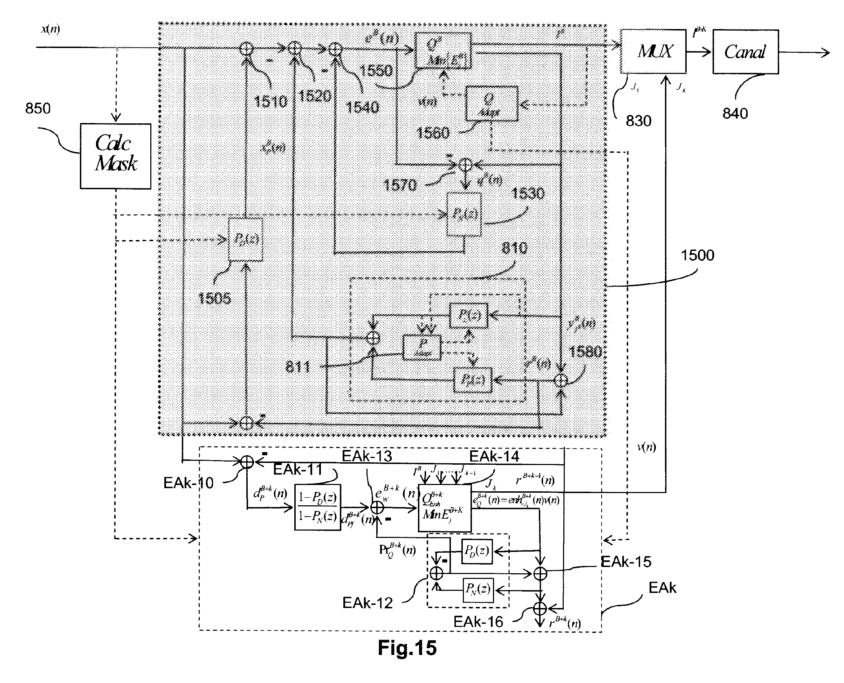

La **figure 15** propose un deuxième mode de réalisation d'un codeur selon l'invention.

Ce mode de réalisation utilise des modules de prédictions à la place des modules de filtrage décrits en référence à la figure 8, à la fois pour l'étage de codage coeur que pour les étages de codage d'amélioration.

Dans ce mode de réalisation, le codeur de type MICDA avec mise en forme du bruit de quantification de coeur comporte un module de prédiction 1505 du bruit de reconstruction $P_D(z)[X(z) - R^B(z)]$, différence entre le signal d'entrée $x(n)$ et le signal synthétisé bas débit $r^B(n)$ et un module d'addition 1510 de la prédiction au signal d'entrée $x(n)$.

Il comporte aussi un module de prédiction 810 du signal $x_P^B(n)$ identique à celui décrit en référence à la figure 8, réalisant une prédiction à partir des échantillons précédents du signal d'erreur quantifié

$$e_Q^B(n') = y_{I^B}^B(n')v(n') \ n' = n-1,...,n-N_Z$$ via l'indice de quantification bas débit $I^B(n)$ et du signal reconstitué $r^B(n')$

$n' = n - 1,..., n - N_P$. Un module de soustraction 1520 de la prédiction $x_P^B(n)$ au signal d'entrée $x(n)$ modifié fournit un signal d'erreur de prédiction.

Le codeur coeur comporte également un module $P_N(z)$ 1530 de calcul de la prédiction du bruit réalisée à partir des échantillons du bruit de quantification précédents $q^B(n')$ $n' = n - 1,..., n - N_{NH}$ et un module de soustraction 1540 de la prédiction ainsi obtenue au signal d'erreur de prédiction pour obtenir un signal d'erreur noté $e^B(n)$.

Un module de quantification de coeur $Q^B$ en 1550 effectue une minimisation du critère d'erreur quadratique

$$E_j^B = \left[ e^B(n) - y_j^B(n)v(n) \right]^2 \ j = 0,...,N_Q - 1$$ où les valeurs $y_j^B(n)$ sont les niveaux reconstruits et $v(n)$ le facteur d'échelle issu du module d'adaptation 1560 du quantificateur. Le module de quantification reçoit en entrée le signal d'erreur $e^B(n)$ pour donner en sortie des indices de quantification $I^B(n)$ et le signal quantifié $e_Q^B(n) = y_{I^B}^B(n)v(n)$ . A

titre d'exemple pour le G.722, les niveaux de reconstruction du quantificateur de coeur $Q^B$ sont définis par le tableau VI de l'article de X. Maitre. "7 kHz audio coding within 64 kbit/s". IEEE Journal on Selected Areas in Communication, Vol.6-2, February 1988".

L'indice de quantification $I^B(n)$ de $B$ bits en sortie du module de quantification $Q^B$ sera multiplexé en 830 avec les bits d'amélioration $J_1,..., J_k$ avant d'être transmis via le canal de transmission 840 au décodeur tel que décrit en référence à la figure 7.

Un module de calcul du bruit de quantification 1570 effectue la différence entre l'entrée du quantificateur et la sortie du quantificateur $q_Q^B(n) = e_Q^B(n) - e^B(n)$ .

Un module 1580 calcule le signal reconstruit en ajoutant la prédiction du signal à l'erreur quantifiée

$$r^B(n) = e_Q^B(n) + x_P^B(n) .$$

Le module d'adaptation $Q_{Adapt}$ 1560 du quantificateur donne un paramètre de contrôle de niveau $v(n)$ encore appelé facteur d'échelle pour l'instant suivant.

Un module d'adaptation $P_{Adapt}$ 811 du module de prédiction effectue une adaptation à partir des échantillons passés du signal reconstruit $r^B(n)$ et du signal d'erreur quantifié reconstruit $e_Q^B(n)$ .

L'étage d'amélioration EAk comporte un module EAk-10 de soustraction du signal reconstitué à l'étage précédant $r^{B+k-1}(n)$ du signal d'entrée $x(n)$ pour donner le signal $d_P^{B+k}(n)$ .

Le filtrage du signal $d_P^{B+k}(n)$ s'effectue par le module de filtrage EAk-11 par le filtre $W(z) = \dfrac{1 - P_D(z)}{1 - P_N(z)}$ pour

donner le signal filtré $d_{Pf}^{B+k}(n)$ .

Un module EAk-12 de calcul d'un signal de prédiction $Pr_Q^{B+k}(n)$ est également prévu, le calcul s'effectuant à partir des échantillons précédents quantifiés du signal d'erreur quantifié $e_Q^{B+k}(n')$ $n' = n-1,...,n-N_D$ et des échantillons de ce signal filtrés par $\dfrac{1 - P_D(z)}{1 - P_N(z)}$ . L'étage d'amélioration EA-k comporte aussi un module de soustraction EA-k13 de la prédiction $Pr_Q^{B+k}(n)$ au signal $d_{Pf}^{B+k}(n)$ pour donner un signal cible $e_w^{B+k}(n)$ .

Le module de quantification d'amélioration EAk-14 $Q_{Enh}^{B+k}$ effectue une étape de minimisation du critère d'erreur quadratique:

$$E_j^{B+k} = \left[ e_w^{B+k}(n) - enh_{vj}^{B+k}(n)v(n) \right]^2 j = 0,1$$

Ce module reçoit en entrée le signal $e_w^{B+k}(n)$ et fournit pour première sortie le signal quantifié

$e_Q^{B+k}(n) = enh_{vJ_k}^{B+k}(n)v(n)$ et pour seconde sortie l'indice $J_k$.

Les niveaux reconstruits du quantificateur imbriqué à B+k bits sont calculés en dédoublant les niveaux de sortie imbriqués du quantificateur à B+k-1 bits. Des valeurs différences entre ces niveaux reconstruits du quantificateur imbriqué à B+k bits et ceux du quantificateur à B+k-1 bits sont calculées. Les valeurs de différence $enh_{v_j}^{B+k}(n)$ $j = 0,1$ sont ensuite stockées une fois pour toute en mémoire du processeur et sont indexés par la combinaison de l'indice de quantification de coeur et des indices des quantificateurs d'amélioration des étages précédents.

Ces valeurs de différence constituent ainsi un dictionnaire qui est utilisé par le module de quantification de l'étage k pour obtenir les valeurs possibles de quantification.

Un module d'addition EAk-15 du signal en sortie du quantificateur $e_Q^{B+k}(n)$ à la prédiction $\mathrm{Pr}_Q^{B+k}(n)$ est aussi intégré à l'étage d'amélioration k ainsi qu'un module EAk-16 d'addition du signal précédant au signal reconstitué à l'étage précédent $r^{B+k-1}(n)$ pour donner le signal reconstitué à l'étage k, $r^{B+k}(n)$.

Comme pour le codeur décrit en référence à la figure 8, le module *Calc Mask* 850 détaillé précédemment fournit le filtre de masquage soit à partir du signal d'entrée (figure 13) soit à partir des coefficients des filtres de synthèse MICDA comme explicité en référence à la figure 14.

Ainsi, l'étage d'amélioration k met en oeuvre les étapes suivantes pour un échantillon courant:

- obtention d'un signal différence $d_P^{B+k}(n)$ par le calcul de la différence entre le signal d'entrée $x(n)$ du codage hiérarchique et un signal reconstruit $r^{B+k-1}(n)$ issu d'un codage d'amélioration d'un étage de codage d'amélioration précédent;

- filtrage du signal différence par un filtre de masquage prédéterminé W(z); - soustraction au signal différence filtré $d_{Pf}^{B+k}(n)$ du signal de prédiction $\mathrm{Pr}_Q^{B+k}(n)$ pour obtenir le signal cible $e_w^{B+k}(n)$;

- calcul du signal en sortie du quantificateur filtré par $\dfrac{1-P_D(z)}{1-P_N(z)}$ par addition du signal $\mathrm{Pr}_Q^{B+k}(n)$ au signal $e_Q^{B+k}(n)$ issu de l'étape de quantification,

- calcul du signal reconstruit $r^{B+k}(n)$ pour l'échantillon courant par addition du signal reconstruit issu du codage d'amélioration de l'étage de codage d'amélioration précédent et du signal filtré précédent.

La figure 15 est donnée pour un filtre de masquage constitué d'une seule cellule ARMA à des fins d'explication simple. Il est entendu que la généralisation à plusieurs cellules ARMA en cascade sera effectuée conformément à la méthode décrite par les équations 7 à 17 et aux figures 9 et 10.

Dans le cas où le filtre de masquage ne comporte qu'une cellule du type 1 - $P_D(z)$, c'est-à-dire $P_N(z) = 0$, la contribution $P_D(z)E_Q^{B+k}(z)$ sera retranchée de $d_{Pf}^{B+k}(n)$ ou mieux le signal d'entrée du quantificateur sera donné en remplaçant EAk-11 et EAk-13 par :

$$E^{B+k}(z) = D_P^{B+k}(z) - P_D(z)\left[ D_P^{B+k}(z) - E_Q^{B+k}(z) \right]$$

Il est entendu que la généralisation à plusieurs cellules AR en cascade sera effectuée conformément à la méthode décrite par les équations 7 à 17 et aux figures 9 et 10.

La **figure 16** représente un troisième mode de réalisation de l'invention avec cette fois ci un étage de codage coeur de type MIC. L'étage de codage coeur 1600 comporte une mise en forme du bruit de codage par l'intermédiaire d'un module de prédiction $P_r(z)$ 1610 calculant la prédiction du bruit $p_R^{BK_M}(n)$ à partir des échantillons précédents du bruit de quantification MIC normalisé G.711 $q_{MIC}^B(n')$ $n' = n-1,...,n-N_{NH}$ et du bruit filtré $q_{MICf}^{BK_M}(n')$ $n' = n-1,...,n-N_{DH}$ .

A noter que la mise en forme de bruit du codage coeur, correspondant aux blocs 1610, 1620, 1640 et 1650 à la figure 16, est optionnelle. L'invention telle que représentée à la figure 16 s'applique même pour un codage coeur MIC réduit au bloc 1630.

Un module 1620 réalise l'addition de la prédiction $p_R^{BK_M}(n)$ au signal d'entrée $x(n)$ pour obtenir un signal d'erreur noté $e(n)$.

Un module de quantification de coeur $Q_{MIC}^B$ 1630 reçoit en entrée le signal d'erreur $e(n)$ pour donner des indices de quantification $I^B(n)$. L'indice de quantification optimal $I^B(n)$ et la valeur quantifiée $e^B_{QMIC}(n) = y^B_{I^B(n)}(n)$ minimisent le critère d'erreur $E^B_j = \left[ e^B(n) - y^B_j(n) \right]^2 \quad j = 0,...,N_Q-1$ où les valeurs $y^B_j(n)$ sont les niveaux reconstruction du quantificateur MIC G.711.

A titre d'exemple, les niveaux de reconstruction du quantificateur de coeur $Q^B_{MIC}$ de la norme G.711 pour B=8 sont définis par le tableau 1a pour la loi A et le tableau 2a pour la loi $\mu$ de la recommandation ITU-T G.711, « Pulse Code Modulation (PCM) of voice frequencies ».).

L'indice de quantification $I^B(n)$ de B bits en sortie du module de quantification $Q^B_{MIC}$ sera concaténé en 830 avec les bits d'amélioration $J_1,..., J_K$ avant d'être transmis via le canal de transmission 840 au décodeur standard de type G.711.

Un module de calcul du bruit de quantification 1640, effectue la différence entre l'entrée du quantificateur MIC et la sortie quantifiée $q^B_{QMIC}(n) = e^B_{QMIC}(n) - e^B(n)$.

Un module de calcul du bruit de quantification filtré 1650 effectue l'addition du bruit de quantification à la prédiction du bruit de quantification $q^{BK_M}_{MICf}(n) = q^B(n) + p^{BK_M}_R(n)$.

Le codage d'amélioration consiste à améliorer la qualité du signal décodé par addition successive de bits de quantification tout en gardant une mise en forme optimale du bruit de reconstruction pour les débits intermédiaires.

L'étage k permettant d'obtenir le bit MIC d'amélioration $J_k$ ou un groupe de bits $J_k$ $k = 1, G_K$ est décrit par le bloc EAk.

Cet étage de codage d'amélioration est similaire à celui décrit en référence à la figure 8.

Il comporte un module de soustraction EAk-1 du signal d'entrée $x(n)$ du signal $r^{B+k}(n)$ formé du signal synthétisé à l'étage k $r^{B+k}(n)$ pour les échantillons $n - N_D,..., n - 1$ et du signal synthétisé à l'étage k-1 $r^{B+k-1}(n)$ pour l'instant n pour donner un signal d'erreur de codage $e^{B+k}(n)$.

Il comporte également un module de filtrage EAk-2 de $e^{B+k}(n)$ par la fonction de pondération $W(z)$ égale à l'inverse du filtre de masquage $H^M(z)$ pour donner un signal filtré $e^{B+k}(n)$,

Le module de quantification EAk-3 effectue une minimisation du critère d'erreur $E^{B+k}_j$ pour $j = 0,1$ réalisant une quantification d'amélioration $Q^k_{enh}$ ayant pour première sortie la valeur du bit MIC optimal $J_k$ à concaténer à l'indice MIC de l'étape précédente $I^{B+k-1}$ et pour deuxième sortie $enh^{B+k}_{v,J_k}(n)$, le signal de sortie du quantificateur d'amélioration pour le bit MIC optimal $J_k$.

Un module d'addition EAk-4 du signal d'erreur quantifiée $enh^{B+k}_{v,J_k}(n)$ au signal synthétisé à l'étape précédente $r^{B+k-1}(n)$ donne le signal synthétisé à l'étape k $r^{B+k}(n)$. Le signal $e^{B+k}(n)$ et les mémoires du filtre sont adaptées comme décrit précédemment pour les figures 6 et 8.

De la même façon que celui décrit en référence à la figure 8 et à la figure 15, le module 850 calcule le filtre de masquage utilisé à la fois pour le codage coeur que pour le codage d'amélioration.

Il est possible d'envisager d'autres versions du codeur hiérarchique, représenté aux figures 8, 15 ou 16. Dans une variante, le nombre de valeurs de quantification possibles dans le codage d'amélioration varie pour chaque échantillon codé. Le codage d'amélioration utilise un nombre de bits variable en fonction des échantillons à coder. Le nombre de bits d'amélioration alloué peut être adapté suivant une règle d'allocation, fixe ou variable. Un exemple d'allocation variable est donné par exemple par le codage MIC d'amélioration de la bande basse dans la norme UIT-T G.711.1. De préférence, l'algorithme d'allocation s'il est variable doit utiliser des informations disponibles au décodeur distant, de sorte qu'aucune information supplémentaire n'ait besoin d'être transmise, ce qui est le cas par exemple dans la norme UIT-T G.711.1.

De façon similaire et dans une autre variante, le nombre d'échantillons codés du signal d'amélioration donnant les indices $(J_k(n))$ de quantification scalaire dans le codage d'amélioration peut être inférieur au nombre d'échantillons du signal d'entrée. Cette variante se déduit de la variante précédente lorsque le nombre de bits d'amélioration alloué est mis à zéro pour certains échantillons.

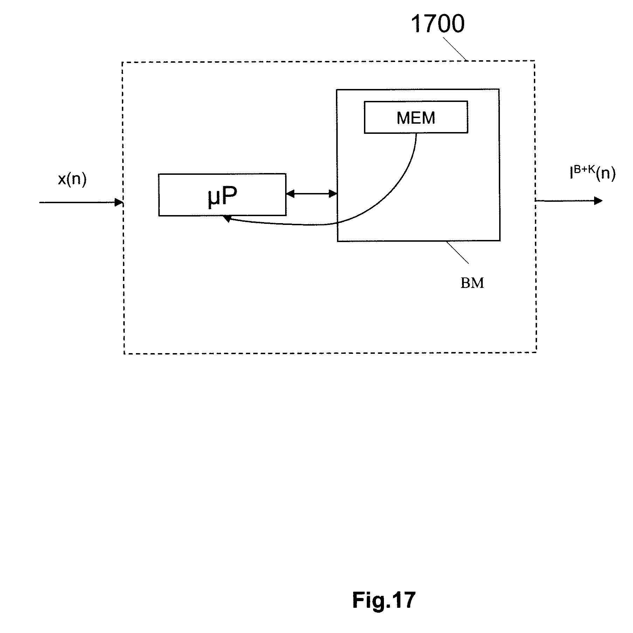

Un exemple de réalisation d'un codeur selon l'invention est maintenant décrit en référence à la **figure 17**.

Matériellement, un codeur tel que décrit selon le premier, le deuxième ou le troisième mode de réalisation au sens de l'invention comporte typiquement, un processeur $\mu$P coopérant avec un bloc mémoire BM incluant une mémoire de stockage et/ou de travail, ainsi qu'une mémoire tampon MEM précitée en tant que moyen pour mémoriser par exemple des valeurs de quantification des étages de codage précédant ou encore un dictionnaire de niveaux de reconstructions de quantification ou toutes autres données nécessaires à la mise en oeuvre du procédé de codage tel que décrit en référence aux figures 6, 8, 15 et 16. Ce codeur reçoit en entrée des trames successives du signal numérique x(n) et délivre des indices de quantification concaténés $I^{B+K}$.

Le bloc mémoire BM peut comporter un programme informatique comportant les instructions de code pour la mise en oeuvre des étapes du procédé selon l'invention lorsque ces instructions sont exécutées par un processeur $\mu$P du codeur et notamment un codage à un débit prédéterminé dit débit coeur, délivrant un indice de quantification scalaire pour chaque échantillon de la trame courante et au moins un codage d'amélioration délivrant des indices de quantification scalaire pour chaque échantillon codé d'un signal d'amélioration. Ce codage d'amélioration comporte une étape d'obtention d'un filtre de mise en forme du bruit de codage utilisé pour déterminer un signal cible. Les indices de quantification scalaire dudit signal d'amélioration, sont déterminés en minimisant l'erreur entre un ensemble de valeurs de quantification scalaire possibles et ledit signal cible.

De manière plus générale, un moyen de stockage, lisible par un ordinateur ou un processeur, intégré ou non au codeur, éventuellement amovible, mémorise un programme informatique mettant en oeuvre un procédé de codage selon l'invention.

Les figures 8, 15 ou 16 peuvent par exemple illustrer l'algorithme d'un tel programme informatique.

## Revendications

1. Procédé de codage hiérarchique d'un signal audionumérique comportant pour une trame courante du signal d'entrée:

   - un codage coeur, délivrant un indice ($I^B(n)$) de quantification scalaire pour chaque échantillon ($x(n)$) de la trame courante et

   - au moins un codage d'amélioration délivrant des indices ($J_k(n)$) de quantification scalaire ($Q_{enh}^k$) pour chaque échantillon codé d'un signal d'amélioration ($enh_{VCj}^{B+k}(n)$),

   caractérisé en ce que le codage d'amélioration comporte une étape d'obtention d'un filtre (W(z)) de mise en forme du bruit de codage utilisé pour déterminer un signal cible et en ce que les indices ($J_k(n)$) de quantification scalaire ($Q_{enh}^k(\mathrm{n})$) dudit signal d'amélioration, sont déterminés en minimisant l'erreur entre un ensemble de valeurs de quantification scalaire possibles et ledit signal cible.

2. Procédé selon la revendication 1, caractérisé en ce que la détermination du signal cible pour un étage de codage d'amélioration courant, comporte les étapes suivantes pour un échantillon courant:

   - obtention d'un signal d'erreur ($e^{B+k}(n)$) de codage d'amélioration par combinaison du signal d'entrée ($x(n)$) du codage hiérarchique avec un signal reconstruit partiellement à partir d'un codage d'un étage de codage précédent et des échantillons passés des signaux reconstruits de l'étage de codage d'amélioration courant;
   - filtrage par le filtre (W(z)) de mise en forme du bruit obtenu, du signal d'erreur de codage d'amélioration pour obtenir le signal cible ($e_{w'}^{B+k}(n)$);
   - calcul du signal reconstruit ($r^{B+k}(n)$) pour l'échantillon courant par addition du signal reconstruit ($r^{B+k-1}(n)$) issu du codage d'un étage de codage précédent et du signal issu de l'étape de quantification ($enh_{2^{I^{B+k-1}}+J_k}^{B+k}(n)v(n)$);
   - adaptation de mémoires du filtre de mise en forme du bruit à partir du signal issu de l'étape de quantification.

3. Procédé selon la revendication 1, caractérisé en ce que l'ensemble des valeurs de quantification scalaires possibles et la valeur de quantification du signal d'erreur pour l'échantillon courant sont des valeurs désignant des niveaux de reconstruction de quantification, mises à l'échelle par un paramètre de contrôle de niveau calculé par rapport aux indices de quantification de débit coeur.

4. Procédé selon la revendication 3, caractérisé en ce que les valeurs désignant des niveaux de reconstructions de quantification pour un étage d'amélioration k sont définis par la différence entre les valeurs désignant les niveaux de reconstruction de la quantification d'un quantificateur imbriqué à B+k bits, B désignant le nombre de bits du codage coeur et les valeurs désignant les niveaux de reconstruction de quantification d'un quantificateur imbriqué à B+k-1 bits, les niveaux de reconstruction du quantificateur imbriqué à B+k bits étant définis par dédoublement des niveaux de reconstruction du quantificateur imbriqué à B+k-1 bits.

**5.** Procédé selon la revendication 4, **caractérisé en ce que** les valeurs désignant des niveaux de reconstruction de quantification pour l'étage d'amélioration k sont stockés dans un espace mémoire et indexés en fonction des indices de quantification de débit coeur et d'amélioration.

**6.** Procédé selon la revendication 1, **caractérisé en ce que** le nombre de valeurs de quantification scalaire possibles varie pour chaque échantillon.

**7.** Procédé selon la revendication 1, **caractérisé en ce que** le nombre d'échantillons codés dudit signal d'amélioration, donnant les indices ($J_k(n)$) de quantification scalaire, est inférieur au nombre d'échantillons du signal d'entrée.

**8.** Procédé selon la revendication 1, **caractérisé en ce que** le codage coeur est un codage MICDA utilisant une quantification scalaire et un filtre de prédiction.

**9.** Procédé selon la revendication 1, **caractérisé en ce que** le codage coeur est un codage MIC.

**10.** Procédé selon l'une des revendications 8 ou 9, **caractérisé en ce que** le codage coeur comprend en outre les étapes suivantes pour un échantillon courant:

- obtention d'un signal de prédiction du bruit $\left( p_R^{BK_M}(n) \right)$ de codage à partir d'échantillons de bruit de quantification passés et à partir d'échantillons passés d'un bruit de quantification filtré par un filtre de mise en forme du bruit prédéterminé;
- combinaison du signal d'entrée du codage coeur et du signal de prédiction du bruit de codage pour obtenir un signal d'entrée modifié à quantifier.

**11.** Procédé selon la revendication 10, **caractérisé en ce que** ledit filtre de mise en forme du bruit (W(z)) utilisé par le codage d'amélioration est également utilisé par le codage coeur.

**12.** Procédé selon la revendication 1 ou 10, **caractérisé en ce que** le filtre de mise en forme du bruit est calculé en fonction dudit signal d'entrée.

**13.** Procédé selon la revendication 1 ou 10, **caractérisé en ce que** le filtre de mise en forme du bruit est calculé à partir d'un signal localement décodé par le codage coeur.

**14.** Codeur hiérarchique d'un signal audionumérique pour une trame courante du signal d'entrée comportant:

- un étage de codage coeur (800, 1500, 1600), délivrant un indice ($I^B(n)$) de quantification scalaire pour chaque échantillon de la trame courante; et
- au moins un étage de codage d'amélioration (EA-k) délivrant des indices ($J_k(n)$) de quantification scalaire $\left( Q_{enh}^k \right)$ pour chaque échantillon codé d'un signal d'amélioration,

**caractérisé en ce que** l'étage de codage d'amélioration comporte un module (850) d'obtention d'un filtre (W(z)) de mise en forme du bruit de codage utilisé pour déterminer un signal cible et un module de quantification (EAk-3, EAk-4) délivrant les indices ($J_k(n)$) de quantification scalaire $\left( Q_{enh}^k(\mathbf{n}) \right)$ dudit signal d'amélioration en minimisant l'erreur entre un ensemble de valeurs de quantification scalaire possibles et ledit signal cible.

**15.** Programme informatique comportant des instructions de code pour la mise en oeuvre des étapes du procédé de codage selon l'une des revendications 1 à 13, lorsque ces instructions sont exécutées par un processeur.

**Patentansprüche**

**1.** Verfahren zum skalierbaren Codieren eines Audiodigitalsignals, umfassend für einen laufenden Raster des Eingangssignals:

- eine Kerncodierung, die einen skalaren Quantifizierungsindex ($I^B(n)$) für jedes Muster ($x(n)$) des laufenden Rasters liefert, und

- mindestens eine Verbesserungscodierung, die Indizes ($J_k(n)$) einer skalaren Quantifizierung ($Q_{enh}^k$) für jedes codierte Muster eines Verbesserungssignals ($enh_{VCj}^{B+K}(n)$) liefert,

**dadurch gekennzeichnet, dass** die Verbesserungscodierung einen Schritt des Erhalts eines Filters ($W(z)$) zur Codierungsrauschtransformation umfasst, der verwendet wird, um ein Zielsignal zu bestimmen, und dass die Indizes ($J_k(n)$) einer skalaren Quantifizierung ($Q_{enh}^k(n)$) des Verbesserungssignals bestimmt werden, wobei der Fehler zwischen einer Gesamtheit von möglichen skalaren Quantifizierungswerten und dem Zielsignal minimiert wird.

2. Verfahren nach Anspruch 1, **dadurch gekennzeichnet, dass** die Bestimmung des Zielsignals für eine laufende Verbesserungscodierungsstufe die folgenden Schritte für ein laufendes Muster umfasst:

- Erhalt eines Fehlersignals ($e^{B+k}(n)$) einer Verbesserungscodierung durch Kombination des Eingangssignals ($x(n)$) der skalierbaren Codierung mit einem Signal, das teilweise aus einer Codierung einer vorherigen Codierungsstufe und vergangenen Mustern der rekonstruierten Signale der laufenden Verbesserungscodierungsstufe rekonstruiert wurde;
- durch den erhaltenen Rauschtransformationsfilter ($W(z)$) Filtern des Fehlersignals einer Verbesserungscodierung, um das Zielsignal ($E_w^{B+k}(n)$) zu erhalten,
- Berechnen des rekonstruierten Signals ($r^{B+k}(n)$) für das laufende Muster durch Addition des rekonstruierten Signals ($r^{B+k-1}(n)$), das von der Codierung einer vorherigen Codierungsstufe stammt, und des Signals, das von dem Quantifizierungsschritt ($enh_{21}^{B+k}{}_{B+k-1+J_k}(n) v(n)$) stammt;
- Anpassen von Speichern des Rauschtransformationsfilters auf Basis des Signals, das aus der Quantifizierungsstufe stammt.

3. Verfahren nach Anspruch 1, **dadurch gekennzeichnet, dass** die Gesamtheit der möglichen skalaren Quantifizierungswerte und der Quantifizierungswert des Fehlersignals für das laufende Muster Werte sind, die Quantifizierungsrekonstruktionsniveaus bezeichnen, die durch einen Niveaukontrollparameter, der in Bezug zu den Kernmengenquantifizierungsindizes berechnet wird, skaliert werden.

4. Verfahren nach Anspruch 3, **dadurch gekennzeichnet, dass** die Werte, die Quantifizierungsrekonstruktionsniveaus für eine Verbesserungsstufe k bezeichnen, durch die Differenz zwischen den Werten, die Quantifizierungsrekonstruktionsniveaus eines eingebetteten Quantifikators mit B+k Bits bezeichnen, wobei B die Anzahl von Bits der Kerncodierung bezeichnet, und den Werten, die die Quantifizierungsrekonstruktionsniveaus eines eingebetteten Quantifikators mit B+k-1 Bits bezeichnen, definiert sind, wobei die Rekonstruktionsniveaus des eingebetteten Quantifikators mit B+k Bits durch Verdoppelung der Rekonstruktionsniveaus des eingebetteten Quantifikators mit B+k-1 Bits definiert sind.

5. Verfahren nach Anspruch 4, **dadurch gekennzeichnet, dass** die Werte, die Quantifizierungsrekonstruktionsniveaus für die Verbesserungsstufe k bezeichnen, in einem Speicherraum gespeichert und in Abhängigkeit von den Kern- und Verbesserungsmengenquantifizierungsindizes indexiert sind.

6. Verfahren nach Anspruch 1, **dadurch gekennzeichnet, dass** die Anzahl von möglichen skalaren Quantifizierungswerten für jedes Muster variiert.

7. Verfahren nach Anspruch 1, **dadurch gekennzeichnet, dass** die Anzahl von codierten Mustern des Verbesserungssignals, woraus sich die skalaren Quantifizierungsindizes ($J_k(n)$) ergeben, kleiner als die Musterzahl des Eingangssignals ist.

8. Verfahren nach Anspruch 1, **dadurch gekennzeichnet, dass** die Kerncodierung eine MICDA-Codierung ist, die eine skalare Quantifizierung und einen Prädiktionsfilter verwendet.

9. Verfahren nach Anspruch 1, **dadurch gekennzeichnet, dass** die Kerncodierung eine MIC-Codierung ist.

10. Verfahren nach einem der Ansprüche 8 oder 9, **dadurch gekennzeichnet, dass** die Kerncodierung ferner die folgenden Schritte für ein laufendes Muster umfasst:

- Erhalt eines Prädiktionssignals des Codierungsrauschens $(p_{\mathrm{R}}^{\mathrm{BK_M}}(n))$ auf Basis von vergangenen Quantifizierungsrauschmustern und von vergangenen Mustern eines Quantifizierungsrauschens, das durch einen Filter zur Transformation des vorbestimmten Rauschens gefiltert wurde;
- Kombination des Eingangssignals der Kerncodierung und des Prädiktionssignals des Codierungsrauschens, um ein zu quantifizierendes modifiziertes Eingangssignal zu erhalten.

11. Verfahren nach Anspruch 10, **dadurch gekennzeichnet, dass** der Rauschtransformationsfilter (W(z)), der für die Verbesserungscodierung verwendet wird, auch für die Kerncodierung verwendet wird.

12. Verfahren nach Anspruch 1 oder 10, **dadurch gekennzeichnet, dass** der Rauschtransformationsfilter in Abhängigkeit vom Eingangssignal berechnet wird.

13. Verfahren nach Anspruch 1 oder 10, **dadurch gekennzeichnet, dass** der Rauschtransformationsfilter auf Basis eines lokal durch die Kerncodierung decodierten Signals berechnet wird.

14. Skalierbarer Codierer eines Audiodigitalsignals für einen laufenden Raster des Eingangssignals, umfassend:

- eine Kerncodierungsstufe (800, 1500, 1600), die einen skalaren Quantifizierungsindex ($I^B$(n)) für jedes Muster des laufenden Rasters liefert, und
- mindestens eine Verbesserungscodierungsstufe (EA-k), die Indizes ($J_k$(n)) einer skalaren Quantifizierung $(Q_{\mathrm{enh}}^{\mathrm{k}})$ für jedes codierte Muster eines Verbesserungssignals liefert,

**dadurch gekennzeichnet, dass** die Verbesserungscodierungsstufe ein Modul (850) für den Erhalt eines Filters (W(z)) zur Codierungsrauschtransformation, der verwendet wird, um ein Zielsignal zu bestimmen, und ein Quantifizierungsmodul (EAk-3, EAk-4) umfasst, das die Indizes ($J_k$(n)) einer skalaren Quantifizierung $(Q_{\mathrm{enh}}^{\mathrm{k}}(n))$ des Verbesserungssignals liefert, wobei der Fehler zwischen einer Gesamtheit von möglichen skalaren Quantifizierungswerten und dem Zielsignal minimiert wird.

15. Informatikprogramm, umfassend Codebefehle für den Einsatz der Schritte des Codierungsverfahrens nach einem der Ansprüche 1 bis 13, wenn diese Befehle von einem Prozessor ausgeführt werden.

**Claims**

1. Method of hierarchical coding of a digital audio signal comprising for a current frame of the input signal:

- a core coding, delivering a scalar quantization index ($I^B$(n)) for each sample (x(n)) of the current frame and
- at least one enhancement coding delivering indices ($J_k$(n)) of scalar quantization ( $Q_{enh}^{k}$ ) for each coded sample of an enhancement signal ( $enh_{VCj}^{B+k}(n)$ ) ,

**characterized in that** the enhancement coding comprises a step of obtaining a filter (W(z)) for shaping the coding noise used to determine a target signal and **in that** the indices ($J_k$(n)) of scalar quantization ( $Q_{enh}^{k}(\mathrm{n})$ ) of said enhancement signal are determined by minimizing the error between a set of possible values of scalar quantization and said target signal.

2. Method according to Claim 1, **characterized in that** the determination of the target signal for a current enhancement coding stage, comprises the following steps for a current sample:

- obtaining an enhancement coding error signal ($e^{B+k}(n)$) by combining the input signal ($x(n)$) of the hierarchical coding with a signal reconstructed partially on the basis of a coding of a previous coding stage and of the past samples of the reconstructed signals of the current enhancement coding stage;
- filtering by the noise shaping filter ($W(z)$) obtained, of the enhancement coding error signal so as to obtain the target signal ($e_w^{B+k}(n)$);
- calculation of the reconstructed signal ($r^{B+k}(n)$) for the current sample by addition of the reconstructed signal ($r^{B+x-1}(n)$) arising from the coding of a previous coding stage and of the signal arising from the quantization step ($enh_{2I^{B+k-1}+J_k}^{B+k}(n)v(n)$);
- adaptation of memories of the noise shaping filter on the basis of the signal arising from the quantization step.

3. Method according to Claim 1, **characterized in that** the set of the possible scalar quantization values and the quantization value of the error signal for the current sample are values denoting quantization reconstruction levels, scaled by a level control parameter calculated with respect to the core bitrate quantization indices.

4. Method according to Claim 3, **characterized in that** the values denoting quantization reconstruction levels for an enhancement stage k are defined by the difference between the values denoting the reconstruction levels of the quantization of an embedded quantizer with B+k bits, B denoting the number of bits of the core coding and the values denoting the quantization reconstruction levels of an embedded quantizer with B+k-1 bits, the reconstruction levels of the embedded quantizer with B+k bits being defined by splitting the reconstruction levels of the embedded quantizer with B+k-1 bits into two.

5. Method according to Claim 4, **characterized in that** the values denoting quantization reconstruction levels for the enhancement stage k are stored in a memory space and indexed as a function of the core bitrate quantization and enhancement indices.

6. Method according to Claim 1, **characterized in that** the number of possible values of scalar quantization varies for each sample.

7. Method according to Claim 1, **characterized in that** the number of coded samples of said enhancement signal, giving the scalar quantization indices ($J_k(n)$), is less than the number of samples of the input signal.

8. Method according to Claim 1, **characterized in that** the core coding is an ADPCM coding using a scalar quantization and a prediction filter.

9. Method according to Claim 1, **characterized in that** the core coding is a PCM coding.

10. Method according to one of Claims 8 and 9, **characterized in that** the core coding furthermore comprises the following steps for a current sample:

- obtaining a prediction signal for the coding noise ($p_R^{BK_M}(n)$) on the basis of past quantization noise samples and on the basis of past samples of quantization noise filtered by a predetermined noise shaping filter;
- combining the input signal of the core coding and the coding noise prediction signal so as to obtain a modified input signal to be quantized.

11. Method according to Claim 10, **characterized in that** said noise shaping filter ($W(z)$) used by the enhancement coding is also used by the core coding.

12. Method according to Claim 1 or 10, **characterized in that** the noise shaping filter is calculated as a function of said input signal.

13. Method according to Claim 1 or 10, **characterized in that** the noise shaping filter is calculated on the basis of a signal locally decoded by the core coding.

14. Hierarchical coder of a digital audio signal for a current frame of the input signal comprising:

- a core coding stage (800, 1500, 1600), delivering a scalar quantization index ($I^B(n)$) for each sample of the current frame; and

- at least one enhancement coding stage (EA-k) delivering indices ($J_k(n)$) of scalar quantization ($Q_{enh}^k$) for each coded sample of an enhancement signal,

**characterized in that** the enhancement coding stage comprises a module (850) for obtaining a filter (W(z)) for shaping the coding noise used to determine a target signal and a quantization module (EAk-3, EAk-4) delivering the indices ($J_k(n)$) of scalar quantization ($Q_{enh}^k(n)$) of said enhancement signal by minimizing the error between a set of possible values of scalar quantization and said target signal.

15. Computer program comprising code instructions for the implementation of the steps of the coding method according to one of Claims 1 to 13, when these instructions are executed by a processor.

Fig.1

**Fig.2**

Fig.3

EP 2 366 177 B1

**Fig.4**

Fig.5

$r^{B+k-1}(n)$

$r^{B+k}(n)$

EAk-4

$v(n)\ I^{B+k-1}(n)$

EAk-3

$J_k(n)$

$Q_{enh}^k$
$Min\{E_j^{B+k}\}$

$e_w^{B+k}(n)$

$enh_{2I^{B+k-1}+J_k}^{B+k}(n)v(n)$

$r^{B+k}(n)$

EAk-2

W(z)

$e^{B+k}(n)$

EAk-1

$e^{B+k}(n')=x(n')-r^{B+k}(n')$
$n'=n-1,...,n-N_D$
$=x(n')-r^{B+k-1}(n')\ n'=n$

$x(n)$

$r^{B+k-1}(n)$

**Fig.6a**

**Fig.6b**

**Fig.7**

Fig.8

Fig.9

Fig.10

EP 2 366 177 B1

0       → 0.06817

        0.03 409     -0.03408

        0.10460     0.03643

0.29212 → 0.21389

        0.17746     -0.03643

        0.25300     0.03911

→ 0.37035

        0.33124     -0.03911

        0.41 259     0.04224

0.63107 → 0.53929

        0.49706     -0.04223

        0.58518     0.04589

→ 0.72286

        0.67697     -0.04589

        0.77310     0.05024

1.03485 → 0.92383

        0.87359     -0.05024

        0.97934     0.05551

→ 1.14587

        1.09036     -0.05551

        1.20788     0.06201

1.39391

        1.33191     -0.062

        1.46415     0.07024

$$y_i^B \qquad y_i^{B+1} \qquad y_i^{B+2} \qquad enh_{I^{B+1}+j}^{B+2} \quad I^{B+1} = 0,...,2^B - 1; \; j = 0,1$$

B=4 bits      B+1 bits      B+2 bits

# Fig.11

$$enh_{VP}^{B+k}(n') = enh_{2I^{B+k-1}+J_k(n')}^{B+k}(n')v(n') \quad n' = -\infty,...,n-1$$

$$= 0 \quad n' = n$$

$$enh_{VCj}^{B+k}(n') = enh_{2I^{B+k-1}+j}^{B+k}(n')v(n') \quad n' = n$$

$$= 0 \quad n' = n-1, n-2,...$$

$$enh_{Vj}^{B+k}(n)$$

Fig.12

# Fig.14

E70: $\dfrac{1+P_z(z)}{1-P_p(z)}$

E71: $Calc$ $1-P_{com}(z)$

E72: Amortissement

E73: $\dfrac{1+P_z(z/g_Z)}{1-P_p(z/g_P)}$

E74: $1-\displaystyle\sum_{i=1}^{2}p_P(i)g_{Com}^i z^{-i}$

$H^M(z)$

# Fig.13

$s(n)$
$n=0,...,N-1$

E60: $A_1(z)$

E61: $Fenêtrage$

E62: Cor(k)

E63: Levinson

E64: $\dfrac{1}{1-A_1(z)}\dfrac{1}{1-A_2(z)}$

E65: $\dfrac{1-P_{N1}(z)}{1-P_{D1}(z)}\dfrac{1-P_{N2}(z)}{1-P_{D2}(z)}$

Fig.15

Fig.16

**Fig.17**

**EP 2 366 177 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2742568

**Littérature non-brevet citée dans la description**

- **X. MAITRE.** 7 kHz audio coding within 64 kbit/s. *IEEE Journal on Selected Areas in Communication,* Février 1988, vol. 6-2

- **Y. HIWASAKI ; S. SASAKI ; H. OHMURO ; T. MORI ; J. SEONG ; M. S. LEE ; B. KÔVESI ; S. RAGOT ; J.-L. GARCIA ; C. MARRO ,L. M.** G.711.1: A wideband extension to ITU-T G.711. *EUSIPCO,* 2008